(19) **Europäisches Patentamt / European Patent Office / Office européen des brevets**

(11) **EP 4 524 104 A1**

(12) **EUROPEAN PATENT APPLICATION**
published in accordance with Art. 153(4) EPC

(43) Date of publication:
19.03.2025 Bulletin 2025/12

(21) Application number: 22941696.1

(22) Date of filing: 12.05.2022

(51) International Patent Classification (IPC):
C01B 33/18 (2006.01)     B82B 1/00 (2006.01)
B82Y 20/00 (2011.01)     C09K 11/59 (2006.01)
H01L 33/06 (2010.01)     H01L 33/34 (2010.01)

(52) Cooperative Patent Classification (CPC):
B82B 1/00; B82B 3/00; B82Y 20/00; C01B 33/023;
C01B 33/18; C09K 11/59; H10F 77/14;
H10H 20/812; H10H 20/826

(86) International application number:
PCT/JP2022/020113

(87) International publication number:
WO 2023/218617 (16.11.2023 Gazette 2023/46)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: M. Technique Co., Ltd.
Izumi-shi, Osaka 594-1144 (JP)

(72) Inventors:
• ENOMURA, Masakazu
  Izumi-shi, Osaka 594-1144 (JP)
• OHKAWA, Hideki
  Izumi-shi, Osaka 594-1144 (JP)

(74) Representative: Marks & Clerk LLP
15 Fetter Lane
London EC4A 1BW (GB)

(54) **SINGLE-CRYSTAL SPHERICAL SILICON NANOPARTICLES**

(57) The present disclosure relates to single-crystal spherical silicon nanoparticles which are monocrystalline are spherical and have an average particle diameter of 1 nm to 20 nm as well as a method of producing the same. The single-crystal spherical silicon nanoparticles of the present invention can produce fluorescence at a high fluorescence quantum efficiency upon excitation by light in a wide range of wavelengths from deep ultraviolet light having a wavelength of 200 nm to 300 nm to visible light, and can increase the conventionally known fluorescence quantum efficiency of silicon nanoparticles from around 1% to 10% or more.

FIG. 1

5nm

EP 4 524 104 A1

**Description**

TECHNICAL FIELD

The present invention relates to single-crystal spherical silicon nanoparticles.

BACKGROUND ART

Silicon is a semiconductor that has been supporting the development of electronics in recent years. For applications thereof to light emitting elements, research and development in the field of silicon photonics have been underway since it was confirmed in 1990 that silicon in a porous form can emit visible light. Silicon is a semiconductor, and is classified into two types of semiconductor, direct transition type and indirect transition type, when considering emission and absorption of visible light. In direct transition type semiconductors, the top of the valence band energy and the bottom of the conduction band energy are located at the same momentum in the energy space for momentum, so that the energy of visible light alone can satisfy the momentum, resulting in high efficiency of light emission (fluorescence). However, in indirect transition type semiconductors including ordinary semiconductor silicon, the top of the valence band energy and the bottom of the conduction band energy do not coincide with each other, so that the momentum of lattice vibration of semiconductor silicon is required for light emission in addition to the momentum of visible light, resulting in lower efficiency of light emission (fluorescence) as compared with that of direct transition type semiconductors. In ordinary silicon, fluorescence of near infrared light having a wavelength of about 1 $\mu$m, which is obtained by converting the energy of 1.2 eV corresponding to the band gap into a wavelength, can be obtained. However, by reducing the diameter of silicon nanoparticles to less than 10 nm, fluorescence equivalent to visible light emission has become obtainable. As the reason for this, it is pointed out that nanosized silicon transitions from the indirect transition type to the direct transition type. **In** the case of silicon nanoparticles oxidized from the surface, since the substantial diameter of silicon nanoparticles that contributes to visible light emission decreases, a silicon particle diameter up to 20 nm is actually acceptable.

Regarding silicon nanoparticles that produce visible light fluorescence, Patent Literature 1 discloses a method of producing silicon nanoparticles by: employing commercially available silicon particles (particle diameter: 100nm, silicon purity: 98% or more); treating crystalline silicon powder with hydrofluoric acid to remove an oxide film on the surface; oxidizing the surface again with nitric acid to form an oxide film; and removing the oxide film with hydrofluoric acid. However, because commercially available silicon particles are used, the produced silicon nanoparticles are not monocrystalline, and the particles obtained in Example 2 had a particle size distribution with two peaks at around 2000 nm and at 10 to 20 nm. In addition, because this production method uses acid substances, i.e., hydrofluoric acid and nitric acid, the handling thereof requires great care, and it is difficult to easily produce silicon nanoparticles industrially.

Patent Literature 2 discloses a method of producing silicon nanoparticles by irradiating silicon powder with a pulse laser and depositing evaporated silicon on a desired substrate. However, the produced silicon nanoparticles had a particle diameter of 50 to 100 nm. In addition, this production method requires a laser capable of oscillating pulses, so that it is not possible to produce semiconductor silicon fine particles at low cost.

Patent Literature 3 discloses a method of producing silicon nanoparticles by reducing a reverse micelle structure obtained by mixing a silicon compound and an alcohol as silicon raw material compounds with a reducing substance. However, Patent Literature 3 describes silicon nanoparticles obtained in the experiment No.9 emit fluorescence in an ultraviolet wavelength range of 300 nm to 350 nm, which is not in the wavelength range of visible light. Therefore, the industrial application scope of the silicon nanoparticles is narrow, and they cannot be applied to the field of lighting and display.

Patent Literature 4 discloses a method of producing silicon nanoparticles in an organic solvent using a reducing agent with a reaction temperature of 0°C or less. It describes in [0065] to [0067] that the reaction temperature is limited to 0°C or less in order to suppress a side reaction and the like. However, it is not described whether the produced silicon nanoparticles are monocrystalline and spherical. In addition, because this is a production method performed in a flask under closed conditions and silicon nanoparticles are produced in an atmosphere in which produced silicon nanoparticles and a reactant coexist, there is concern about a side reaction between the silicon nanoparticles and the reactant. In Example 1, a tetrahydrofuran (THF) solution of DBB (4,4'-di-tert-butylbiphenyl) was added to metal lithium and stirred at room temperature for 2 to 4 hours to prepare a reduction liquid. Silicon tetrachloride was added thereto all at once at -60°C to allow reaction, thereby producing chlorine-terminated silicon nanoparticles. The nanoparticles were subjected to surface stabilization treatment with hexylmagnesium bromide to prepare alkyl group-terminated silicon nanoparticles. However, as described in Comparative Example 1 of the present specification, the alkyl group-terminated silicon nanoparticles of Example 1 of Patent Literature 4 are polycrystalline, not monocrystalline and spherical.

Patent Literature 5 by the applicant of the present application discloses a method of producing silicon nanoparticles by using a fluid processing apparatus having processing surfaces being capable of approaching to and separating from each other and rotating relative to each other. It also describes that the produced silicon nanoparticles can produce fluorescence from blue to near infrared according to change in production temperature. However, it does not disclose that the silicon nanoparticles are monocrystalline and spherical. In Examples 6 to 9, a THF solution of DBB was added to metal lithium and stirred at room temperature to prepare a reduction liquid; silicon tetrachloride was reacted with the reduction liquid at a temperature of -50°C to -90°C using the above fluid processing apparatus to produce chlorine-terminated silicon nanoparticles; these nanoparticles were subjected to surface stabilization treatment with hexylmagnesium bromide to produce alkyl group-terminated silicon nanoparticles. However, as described in Comparative Example 1 of the present specification, the alkyl group-terminated silicon nanoparticles of Example 6 of Patent Literature 5 are polycrystalline, not monocrystalline and spherical.

CITATION LIST

PATENT LITERATURE

Patent Literature 1: JP 2014-172766
Patent Literature 2: JP 2017-081770
Patent Literature 3: JP 2010-205686
Patent Literature 4: JP 2007-012702
Patent Literature 5: JP 4458202

SUMMARY OF THE INVENTION

TECHNICAL PROBLEM

The problem of the present invention is to provide silicon nanoparticles that can produce blue to orange fluorescence at a high fluorescence quantum efficiency upon excitation by light in a wide range of wavelengths from deep ultraviolet light having a wavelength of 200 nm to 300 nm to visible light, and can fill an electrode material of solar cells and secondary ion batteries and the like at a high density.

SOLUTION TO THE PROBLEM

The inventors of the present application made intensive studies to solve the above problem and have found that because single-crystal spherical silicon nanoparticles that are monocrystalline and spherical and have an average particle diameter of 1 nm to 20 nm are each a single crystal with no grain boundaries that reduce fluorescence efficiency, they can produce blue to orange fluorescence at a high fluorescence quantum efficiency upon excitation by light in a wide range of wavelengths from deep ultraviolet light having a wavelength of 200 nm to 300 nm to visible light, and can fill an electrode material of solar cells and secondary ion batteries and the like at a high density. Thus, the present inventors have completed the present invention.

That is, the present invention is as follows.

[1] Single-crystal spherical silicon nanoparticles, wherein the single-crystal spherical silicon nanoparticles are monocrystalline and spherical, and an average particle diameter of the single-crystal spherical silicon nanoparticles is 1 nm to 20 nm.

[2] The single-crystal spherical silicon nanoparticles according to [1], wherein the circularity of the single-crystal spherical silicon nanoparticles is calculated by a mathematical expression: $4\pi S/Z^2$ using a perimeter (Z) and an area (S) of a projected image of the single-crystal spherical silicon nanoparticles observed by a transmission electron microscope, and an average value of the circularity is 0.9 or more.

[3] The single-crystal spherical silicon nanoparticles according to [1] or [2], wherein the IR absorption spectrum of the single-crystal spherical silicon nanoparticles shows absorption in the wavenumber range of 1950 cm$^{-1}$ to 2150 cm$^{-1}$, and the absorption is attributed to Si-H bond.

[4] The single-crystal spherical silicon nanoparticles according to any one of [1] to [3], wherein the ratio: B/A calculated with A, which is the peak intensity of the maximum peak in the wavenumber range of 1000 cm$^{-1}$ to 1200 cm$^{-1}$, and B, which is the peak intensity of the maximum peak in the wavenumber range of 400 cm$^{-1}$ to 500 cm$^{-1}$, in the IR absorption spectrum of the single-crystal spherical silicon nanoparticles is less than 0.2.

[5] The single-crystal spherical silicon nanoparticles according to any one of [1] to [4], wherein the ratio: C/A calculated with A, which is the peak intensity of the maximum peak in the wavenumber range of 1000 cm$^{-1}$ to 1200 cm$^{-1}$, and C, which is the peak intensity of the maximum peak in the wavenumber range of 530 cm$^{-1}$ to 630 cm$^{-1}$, in the IR absorption spectrum of the single-crystal spherical silicon nanoparticles is less than 0.2.

[6] The single-crystal spherical silicon nanoparticles according to any one of [1] to [5], wherein the single-crystal spherical silicon nanoparticles exhibit a fluorescence maximum in the wavelength range of 400 nm to 600 nm.

[7] The single-crystal spherical silicon nanoparticles according to any one of [1] to [6], wherein the single-crystal spherical silicon nanoparticles exhibit a fluorescence maximum in the wavelength range of 400 nm to 600 nm by deep ultraviolet light at an excitation light wavelength of 300 nm or less.

ADVANTAGEOUS EFFECTS OF THE INVENTION

Since the single-crystal spherical silicon nanoparticles of the present invention are each a single crystal with no grain boundaries that reduce fluorescence efficiency, they can produce fluorescence at a high fluorescence quantum efficiency upon excitation by light in a wide range of wavelengths from deep ultraviolet light having a wavelength of 200 nm to 300 nm to visible light, and can increase the conventionally known fluorescence quantum efficiency of silicon nanoparticles from around 1% to 10% or more. In addition, the single-crystal spherical silicon nanoparticles of the present invention have no toxicity to the living body that compound semiconductors formed from cadmium, selenium, or tellurium have. Further, since the single-crystal spherical silicon nanoparticles of the present invention are spherical, they can fill an electrode material of solar cells and secondary ion batteries and the like at a high density and can be used as a negative electrode of lithium ion batteries, an electrode material for solar cells, and a bonding material for semiconductor devices to substrates.

BRIEF DESCRIPTION OF THE DRAWINGS

FIG. 1 shows the TEM image of the single-crystal spherical silicon nanoparticles of Example 1-1.

FIG. 2 shows the STEM image of the single-crystal spherical silicon nanoparticles of Example 1-4.

FIG. 3 shows the electron diffraction pattern of the single-crystal spherical silicon nanoparticles of Example 1-4.

FIG. 4 shows the IR spectrum of the single-crystal spherical silicon nanoparticles of Example 1-2 in the wavenumber range of 1800 $cm^{-1}$ to 2300 $cm^{-1}$.

FIG. 5a shows the IR spectrum of the single-crystal spherical silicon nanoparticles of Example 1-4 in the wavenumber range of 900 $cm^{-1}$ to 1300 $cm^{-1}$. The vertical axis represents the absorbance normalized with the peak intensity of the maximum peak in the wavenumber range of 900 $cm^{-1}$ to 1300 $cm^{-1}$ as 1.0.

FIG. 5b shows the IR spectrum of the single-crystal spherical silicon nanoparticles of Example 1-4 in the wavenumber range of 400 $cm^{-1}$ to 550 $cm^{-1}$.

FIG. 5c shows the IR spectrum of the single-crystal spherical silicon nanoparticles of Example 1-4 in the wavenumber range of 450 $cm^{-1}$ to 650 $cm^{-1}$.

FIG. 5d shows the IR spectrum of the single-crystal spherical silicon nanoparticles of Example 1-4 in the wavenumber range of 550 $cm^{-1}$ to 700 $cm^{-1}$.

FIG. 6 shows normalized fluorescence spectra of the single-crystal spherical silicon nanoparticles of Example 1-3 with the maximum intensity set at 1.0, which are the results of changing the excitation wavelength from 340 nm to 500 nm in steps of 40 nm.

FIG. 7 shows the excitation wavelength dependence of the fluorescence peak wavelength of the single-crystal spherical silicon nanoparticles of Example 1-3.

FIG. 8 shows measurement results of the particle diameter and the fluorescence peak wavelength relative to the disk rotation speed of the single-crystal spherical silicon nanoparticles of Example 1-1 to Example 1-4.

FIG. 9 shows the fluorescence spectrum of the single-crystal spherical silicon nanoparticles of Example 1-2 by deep ultraviolet excitation light.

FIG. 10 shows the STEM image of the polycrystalline silicon nanoparticles of Comparative Example 1-1.

FIG. 11 shows the IR spectrum of the polycrystalline silicon nanoparticles of Comparative Example 1-1 in the wavenumber range of 900 $cm^{-1}$ to 1300 $cm^{-1}$.

FIG. 12a shows the IR spectrum of the polycrystalline silicon nanoparticles of Comparative Example 1-1 in the wavenumber range of 900 $cm^{-1}$ to 1300 $cm^{-1}$. The vertical axis represents the absorbance normalized with the peak intensity of the maximum peak in the wavenumber range of 900 $cm^{-1}$ to 1300 $cm^{-1}$ as 1.0.

FIG. 12b shows the IR spectrum of the polycrystalline silicon nanoparticles of Comparative Example 1-1 in the wavenumber range of 400 $cm^{-1}$ to 550 $cm^{-1}$.

FIG. 12c shows the IR spectrum of the polycrystalline silicon nanoparticles of Comparative Example 1-1 in the wavenumber range of 450 $cm^{-1}$ to 650 $cm^{-1}$.

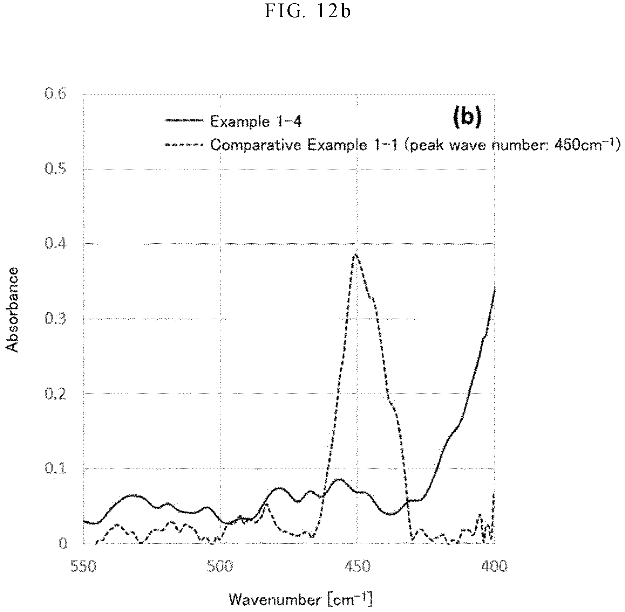

FIG. 12b shows the IR spectrum of the polycrystalline silicon nanoparticles of Comparative Example 1-1 in the wavenumber range of 550 cm$^{-1}$ to 700 cm$^{-1}$.

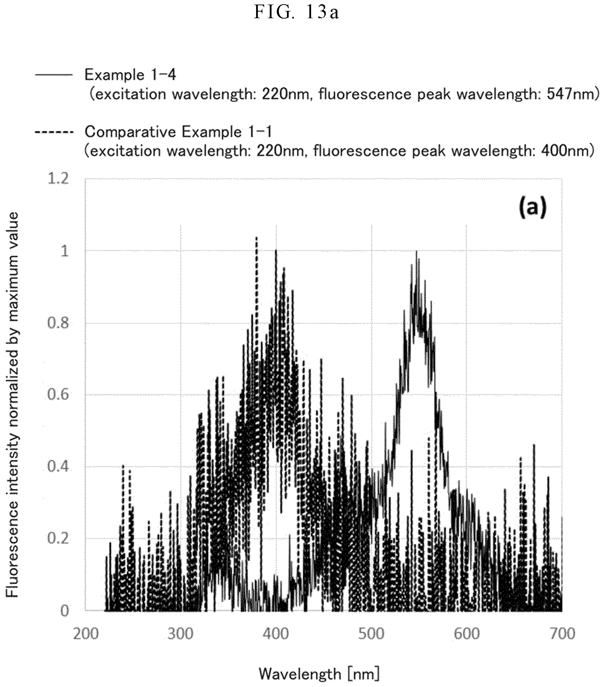

FIG. 13a shows the fluorescence spectrum of the polycrystalline silicon nanoparticles of Comparative Example 1-1 by deep ultraviolet light at an excitation wavelength of 220 nm.

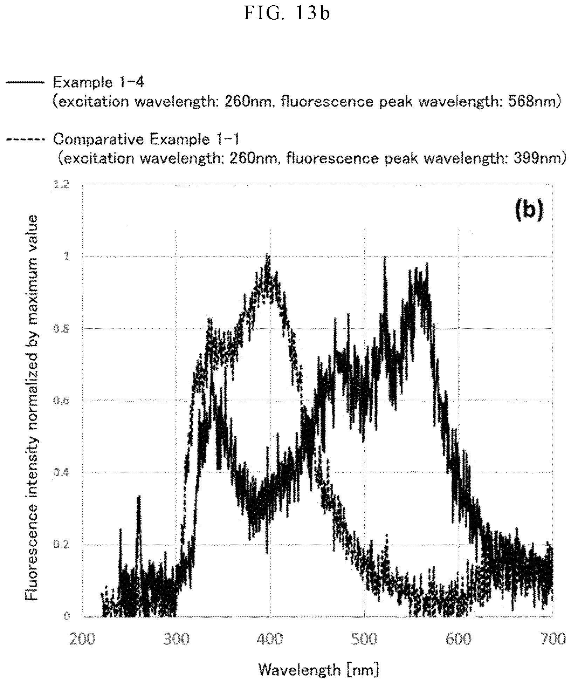

FIG. 13b shows the fluorescence spectrum of the polycrystalline silicon nanoparticles of Comparative Example 1-1 by deep ultraviolet light at an excitation wavelength of 260 nm.

DESCRIPTION OF THE INVENTION

Hereinafter, embodiments of the present invention will be described. However, the present invention is not limited to the embodiments described below. Further, an exemplary application thereof to a light emitting material that emits fluorescence will be described, but the applications of the single-crystal spherical silicon nanoparticles of the present invention are not limited thereto.

1. Single-crystal spherical silicon nanoparticles

The single-crystal spherical silicon nanoparticles of the present invention are monocrystalline and spherical, and have an average particle diameter of 1 nm to 20 nm.

The circularity of the single-crystal spherical silicon nanoparticles is calculated by a mathematical expression: $4\pi S/Z^2$ using a perimeter (Z) and an area (S) of a projected image of the single-crystal spherical silicon nanoparticles observed by a transmission electron microscope. An average value of the circularity of the single-crystal spherical silicon nanoparticles is preferably 0.9 or more, more preferably 0.92 or more, and even more preferably 0.95 or more.

The average particle diameter is preferably 1.2 nm to 10 nm, more preferably 1.5 nm to 7 nm, and even more preferably 2 nm to 5 nm, for example.

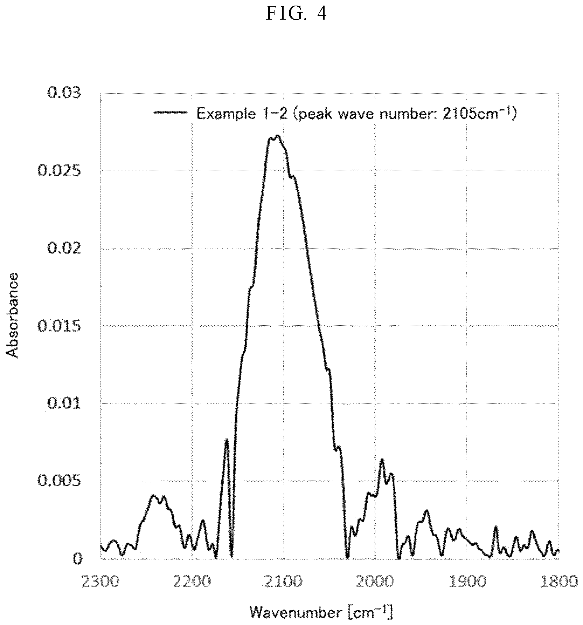

The single-crystal spherical silicon nanoparticles preferably have a Si-H bond on the surface. If there is a portion on the surface of a single-crystal spherical silicon nanoparticle where a bond between silicon atoms is broken, such part is unstable and may generate a new energy level in the band gap, which can affect the fluorescence wavelength. Accordingly, the presence of a Si-H bond, in which a silicon atom whose bond has been broken is bonded to a hydrogen atom, stabilizes the particle and reduces influence on the fluorescence wavelength. Therefore, the single-crystal spherical silicon nanoparticles preferably have absorption in the wavenumber range of 1950 cm$^{-1}$ to 2150 cm$^{-1}$ attributed to stretching vibration of Si-H bond in the IR absorption spectrum. As shown in FIG. 4, the single-crystal spherical silicon nanoparticles of Example 1-2 have an absorption peak at 2105 cm$^{-1}$.

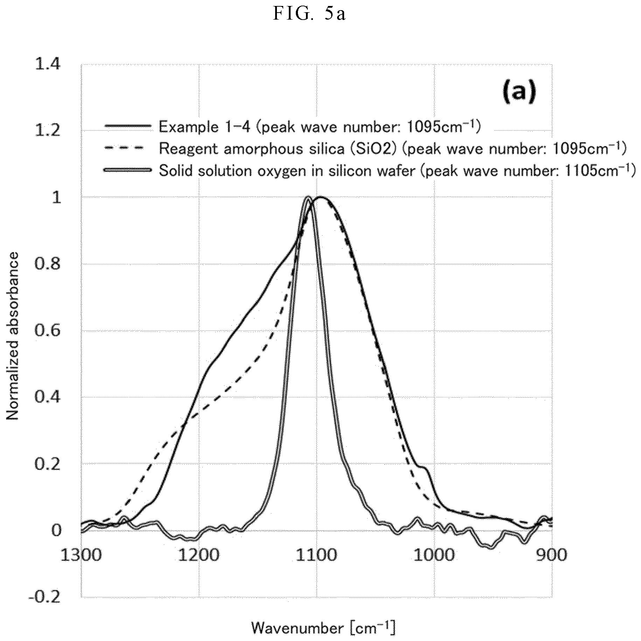

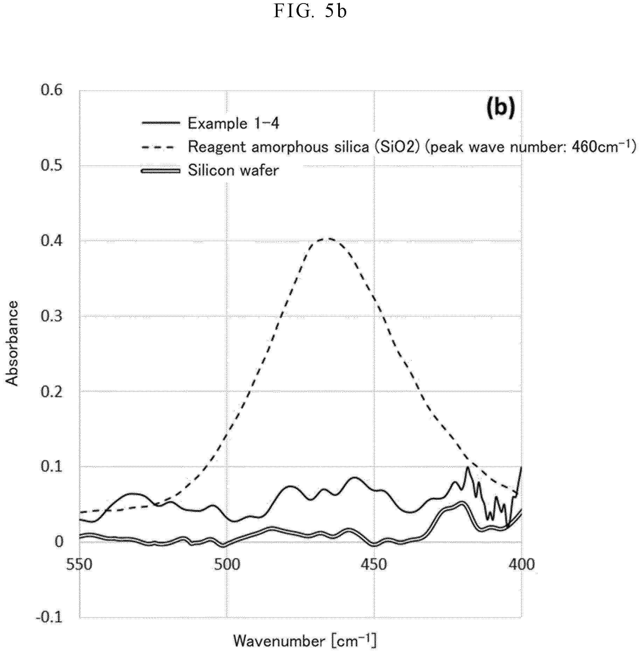

The single-crystal spherical silicon nanoparticles preferably contain as little solid solution oxygen as possible. Specifically, for example, the ratio: B/A calculated with A, which is the peak intensity of the maximum peak in the wavenumber range of 1000 cm$^{-1}$ to 1200 cm$^{-1}$, and B, which is the peak intensity of the maximum peak in the wavenumber range of 400 cm$^{-1}$ to 500 cm$^{-1}$, in the IR absorption spectrum is less than 0.2. For example, as shown in FIG. 5a and FIG. 5b, the single-crystal spherical silicon nanoparticles of Examples 1-1 to 1-4 have the ratio: B/A of 0.08 to 0.10 as shown in Table 3, where A is the peak intensity of the maximum peak at 1095 cm$^{-1}$ and B is the peak intensity of the maximum peak at 460 cm$^{-1}$, which is less than 0.2.

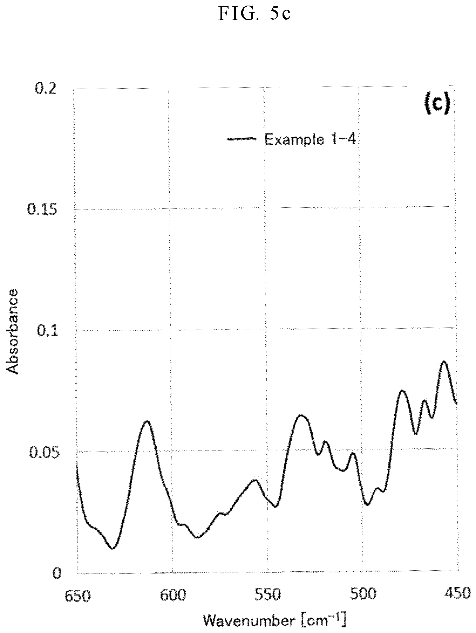

The single-crystal spherical silicon nanoparticles preferably contain as few Si-Cl bonds as possible. Specifically, for example, the ratio: C/A calculated with A, which is the peak intensity of the maximum peak in the wavenumber range of 1000 cm$^{-1}$ to 1200 cm$^{-1}$, and C, which is the peak intensity of the maximum peak in the wavenumber range of 530 cm$^{-1}$ to 630 cm$^{-1}$, in the IR absorption spectrum is less than 0.2. For example, the single-crystal spherical silicon nanoparticles of Examples 1-1 to 1-4 have the ratio: B/A of 0.06 to 0.08 as shown in Table 3, which is less than 0.2, where A is the peak intensity of the maximum peak at 1095 cm$^{-1}$ and C is the peak intensity of the maximum peak at 612 cm$^{-1}$, as shown in FIG. 5a and FIG. 5c.

It is known that fluorescence of silicon nanoparticles occurs by three different mechanisms below.

(A) Control of fluorescence color by controlling a physical factor of changing the band gap of electron energy according to the particle diameter of silicon nanoparticles (known as quantum effect).

(B) Control of fluorescence color via surface substituents in a state where various substituents such as an alkyl group and an amino group with different molecular chain lengths are chemically bonded to the surface of silicon nanoparticles by surface modification of treating the silicon nanoparticles with various chemicals.

(C) Control of fluorescent color by a chemical factor by utilizing a compositional change mediated by oxygen or nitrogen contained in silicon nanoparticles.

In the single-crystal spherical silicon nanoparticles of the present invention, (A) quantum effect mechanism and (C) oxygen mediated mechanism of the three mechanisms (A) to (C) act synergistically to produce fluorescence. This is different from the mechanism of the alkyl group-terminated silicon nanoparticles of Patent Literature 4 and Patent Literature 5, which use (A) quantum effect mechanism and (B) surface modification mechanism.

The single-crystal spherical silicon nanoparticles of the present invention preferably exhibit a fluorescence maximum in the wavelength range of 400 nm to 600 nm. More preferably, they exhibit a fluorescence maximum in the wavelength range of 400 nm to 600 nm by deep ultraviolet light at an excitation light wavelength of 300 nm or less.

2. Method of producing single-crystal spherical silicon nanoparticles

The single-crystal spherical silicon nanoparticles of the present invention can be produced, for example, by mixing a liquid containing a raw material of the single-crystal spherical silicon nanoparticles (Liquid B) and a reduction liquid containing metal lithium and a condensed aromatic compound (Liquid A) in a thin film fluid formed between two processing surfaces arranged to be opposite to each other to be able to approach to and separate from each other, at least one of which rotates relative to the other.

(Single-crystal spherical silicon nanoparticle raw material liquid (Liquid B))

The raw material of the single-crystal spherical silicon nanoparticles is not particularly limited as long as it is a substance capable of precipitating single-crystal spherical silicon nanoparticles by reduction. For example, the raw material may be preferably silicon tetrahalide, more preferably silicon tetrachloride, silicon tetrabromide and silicon tetraiodide, and even more preferably silicon tetrachloride, silicon tetrabromide and the like.

Examples of the single-crystal spherical silicon nanoparticle raw material liquid include a solution in which a raw material of the single-crystal spherical silicon nanoparticles is dissolved in a solvent. The solvent is not particularly limited as long as it can precipitate the single-crystal spherical silicon nanoparticles by reducing the raw material of the single-crystal spherical silicon nanoparticles and it is a substance which is inert and does not affect the reduction reaction. For example, the solvent may be preferably ethers and the like, more preferably tetrahydrofuran (THF), dioxane, 1,2-dimethoxyethane (DME), diethylene glycol dimethyl ether, diethylene glycol diethyl ether, diethyl ether, polyethylene glycol dimethyl ether, and mixtures thereof, and even more preferably THF, dioxane, DME, and the like.

The concentration of the raw material in the single-crystal spherical silicon nanoparticle raw material liquid is not particularly limited, and examples thereof include 0.01 to 1 mol/L, preferably 0.02 to 0.5 mol/L, and more preferably 0.05 to 0.2 mol /L.

(Single-crystal spherical silicon nanoparticle reduction liquid (Liquid A))

A reducing agent contained in the single-crystal spherical silicon nanoparticle reduction liquid is not particularly limited as long as it can precipitate the single-crystal spherical silicon nanoparticles by reducing a raw material of the single-crystal spherical silicon nanoparticles contained in the single-crystal spherical silicon nanoparticle raw material liquid. Examples of the reducing agent include combinations of metal lithium, metal sodium, or metal potassium with a condensed aromatic compound.

Examples of the condensed aromatic compound include those that can receive one electron from metal lithium to produce a lithium ion and a condensed aromatic compound anion (radical anion). The condensed aromatic compound anion with one transferred electron has one electron in the lowest unoccupied molecular orbital (LUMO) of the condensed aromatic compound. For example, when the raw material of the single-crystal spherical silicon nanoparticles is silicon tetrahalide, the potential of the condensed aromatic compound anion needs to be less than -2.0 V in order to reduce silicon tetrahalide to silicon. Here, the potential is a value relative to silver (Ag)/silver chloride (AgCl) as a reference electrode. Examples of the condensed aromatic compound whose potential is less than -2.0 V include naphthalene (-2.53 V), DBB (-2.87 V), biphenyl (-2.68 V), 1,2-dihydronaphthalene (-2.57 V), phenanthrene (-2.49 V), anthracene (-2.04 V), pyrene (-2.13 V), and mixtures thereof, preferably naphthalene, biphenyl, and the like. On the other hand, tetracene (-1.55 V) and azulene (-1.62 V) are not suitable for reducing silicon tetrahalide.

Examples of the molar ratio of metal lithium and the condensed aromatic compound include 1:1 to 1.5:1, preferably 1:1 to 1.2:1, and more preferably 1:1 to 1.1:1.

Examples of the molar ratio of metal lithium and the raw material of the single-crystal spherical silicon nanoparticles include 7:1 to 4:1, preferably 6:1 to 4:1, and more preferably 5:1 to 4:1. It is preferable to use metal lithium in excess of the raw material of the single-crystal spherical silicon nanoparticles. By using an excessive amount of metal lithium, single-crystal spherical silicon nanoparticles with a fewer number of residual halogen elements can be produced. When using metal lithium in an amount smaller than that of the raw material of the single-crystal spherical silicon nanoparticles, for example, when using 3/4 the amount of the raw material as shown in Comparative Example 1, the raw material would not be completely reduced, so that chlorine atoms derived from the raw material remain in the single-crystal spherical silicon nanoparticles. Thus, the resulting silicon nanoparticles become polycrystalline and not spherical.

Examples of the solvent of the single-crystal spherical silicon nanoparticle reduction liquid include the above solvent used in the single-crystal spherical silicon nanoparticle raw material liquid. The concentration of metal lithium in the solvent of the single-crystal spherical silicon nanoparticle reduction liquid is not particularly limited, but is determined according to the molar ratio of metal lithium to the raw material of the single-crystal spherical silicon nanoparticles described above.

It is preferable to prepare the single-crystal spherical silicon nanoparticle reduction liquid by mixing metal lithium and a condensed aromatic compound at a temperature less than 0°C. Examples of the preparation temperature include a temperature from -50°C to less than 0°C, preferably from -40°C to -10°C, and more preferably from -30°C to -15°C. In Example 1, the single-crystal spherical silicon nanoparticle reduction solution was prepared at -20°C. In Example 1 of Patent Literature 4 and Examples 6 to 9 of Patent Literature 5, the reduction liquid was prepared at room temperature. In Comparative Example 1 of the present specification, the inventors conducted a replication test for Example 6 of Patent Literature 5 and prepared the reduction liquid at 15 to 16°C (room temperature). The results were that the reducing agent became unstable, a by-product was generated, and the single-crystal spherical silicon nanoparticles became polycrystalline and not spherical.

A condensed aromatic compound anion generated by electron transfer of an electron of metal lithium to a condensed aromatic compound can bond through Coulomb force with a cation of metal lithium generated by such electron transfer. Accordingly, there is concern that reducing power may change due to reverse electron transfer from a generated condensed aromatic compound anion to a lithium cation. Variation in reducing power affects the particle size distribution of the resulting single-crystal spherical silicon nanoparticles. Suppression of variation in reducing power due to reverse electron transfer can be possible if a lithium cation and a condensed aromatic compound anion are bonded by Coulomb force via a solvent molecule. It is known that such a state of an anion and a cation in a solution can be confirmed by measuring an ultraviolet-visible absorption spectrum. According to the method, in a combination of metal lithium and naphthalene that are dissolved in tetrahydrofuran, which is an ether based organic solvent, the ratio of THF mediated anions and cations at 25°C is 60% to 80%. It is known that, in a combination of metal sodium and naphthalene that are dissolved in THF, a sodium cation and a naphthalene anion are directly bonded with each other by Coulomb force almost with no THF therebetween, but when cooled to -50°C, almost 100% of the cations and anions can bond with each other via THF.

Solvent mediated bonding can be achieved by lowering the temperature of the solvent. That is, solvent mediated bonding means a state where there are a solvated cation in which a lithium cation is surrounded by solvent molecules and a solvated anion in which a condensed aromatic compound anion is surrounded by solvent molecules and the solvent around the cation is in contact with the solvent around the anion. Since it is possible to create, in a solution, such a state where a cation and an anion are in contact with each other via a solvent, the condensed aromatic compound anions can be stably present, and reverse electron transfer from a condensed aromatic compound anion to a lithium cation can be suppressed. However, even if a reaction liquid is prepared so as to have such a solution structure in advance, silicon nanoparticles in the solution may have a particle size distribution if the reaction liquid was prepared in a state where the preparation temperature was 0°C or more and solvation was not sufficiently performed or in a state where there was a distribution in the solvation state. It is because even if such a reaction liquid is cooled to a low temperature when producing silicon nanoparticles, variation in reducing power may occur since solvation was not necessarily carried out completely. In an equilibrium state where ions are directly bonded to each other by Coulomb force at a low temperature, even if the reduction liquid is cooled to a low temperature when preparing silicon nanoparticles, it is difficult for solvent molecules to overcome the Coulomb force and get in between a cation and an anion. Therefore, the temperature at the time of preparation of the reduction liquid is more important than the temperature at the time of production of the silicon nanoparticles.

(Method of producing single-crystal spherical silicon nanoparticles)

The single-crystal spherical silicon nanoparticles of the present invention can be produced, for example, by mixing a liquid containing a raw material of the single-crystal spherical silicon nanoparticles (Liquid B) and a reduction liquid containing metal lithium and a condensed aromatic compound (Liquid A) in a thin film fluid formed between two processing surfaces arranged to be opposite to each other to be able to approach to and separate from each other, at least one of which rotates relative to the other.

Examples of the apparatus used in the production method of the present invention include a fluid processing apparatus as proposed by the present applicant and described in JP 2009-112892. The apparatus comprises a stirring tank having an inner peripheral surface which cross-section is circular, and a mixing tool attached to the stirring tank with a slight gap to the inner peripheral surface of the stirring tank, wherein the stirring tank comprises at least two fluid inlets and at least one fluid outlet; from one of the fluid inlets, the first fluid to be processed containing one of the reactants among the fluids to be processed is introduced into the stirring tank; from one fluid inlet other than the above inlet, the second fluid to be processed containing one of reactants different from the above reactant is introduced into the stirring tank through a different flow path. At least one of the stirring tank and the mixing tool rotates at a high speed relative to the other to let the above fluids be in a state of a thin film; and in the above thin film, the reactants contained in the first and second fluids to be processed are reacted. Examples of the apparatus also include an apparatus based on the same principle as the fluid processing apparatus described in Patent Literature 5.

Preferably, the single-crystal spherical silicon nanoparticles are produced by mixing the liquid containing a raw material of the single-crystal spherical silicon nanoparticles (Liquid B) and the above reduction liquid (Liquid A) at a temperature of less than 5°C in the thin film fluid. The single-crystal spherical silicon nanoparticles are produced in two steps in which a core of a single-crystal spherical silicon nanoparticle is first generated, and then the single-crystal spherical silicon nanoparticle grows. Even if Liquid B comes into contact with Liquid A at 5°C or less and the reaction starts, since the frequency of generation of cores for growth of single-crystal spherical silicon nanoparticles is set low, the frequency of contact between the cores of single-crystal spherical silicon nanoparticles is also decreased. Thereby, the growth of single-crystal spherical silicon nanoparticles becomes less susceptible to change in the concentration of a raw material liquid which is caused by the growth of surrounding single-crystal spherical silicon nanoparticles, and the supply of a raw material necessary for growth of single-crystal spherical silicon nanoparticles can be uniform.

Examples of the temperature of the single-crystal spherical silicon nanoparticle reduction liquid (Liquid A), which is introduced into a thin film fluid formed between two processing surfaces arranged to be opposite to each other to be able to approach to and separate from each other, at least one of which rotates relative to the other, include a temperature of -30°C to 5°C, preferably -10°C to 5°C, and more preferably 0°C to 5°C. In Examples 1 and 2, as a result of the production carried out with Liquid A at 5°C, single-crystal spherical silicon nanoparticles that are monocrystalline and spherical and produce fluorescence at a high fluorescence quantum efficiency could be produced. In Comparative Example 4, as a result of the production carried out with Liquid A at 25°C, the fluorescent quantum efficiency decreased.

In [0065] to [0067] of Patent Literature 4, it is emphasized that the reaction temperature is limited to a temperature of 0°C or less in order to suppress a side reaction and the like, and in the Example thereof, the reaction was carried out at a much lower temperature of -60°C. Also in Examples 6 to 9 of Patent Literature 5, the reaction was carried out at a much lower temperature of -50°C to -90°C. To the contrary, the present invention has a remarkable advantage that extremely satisfactory single-crystal spherical silicon nanoparticles can be obtained even with a reaction temperature of 5°C, which is higher than a temperature of 0°C which was inhibited in Patent Literature 4. This remarkable advantage could not be anticipated by those skilled in the art based on Patent Literature 4 and Patent Literature 5.

Examples of the temperature of the single-crystal spherical silicon nanoparticle raw material liquid (Liquid B), which is introduced into a thin film fluid formed between two processing surfaces arranged to be opposite to each other to be able to approach to and separate from each other, at least one of which rotates relative to the other, include a temperature of -10°C to -25°C, preferably 0°C to 20°C, and more preferably 10°C to 18°C. In Examples 1 and 2, as a result of the production carried out with Liquid B at 15°C, single-crystal spherical silicon nanoparticles that are monocrystalline and spherical and produce fluorescence at a high fluorescence quantum efficiency could be produced.

In the production method of the present invention, since the particle size distribution is narrow and the raw material is isotropically supplied, it is possible to produce single-crystal spherical silicon nanoparticles that are monocrystalline and spherical and produce fluorescence at a high fluorescence quantum efficiency. When the reaction temperature is high, the frequency of generation of cores of single-crystal spherical silicon nanoparticles increases. However, since there are many other cores of single-crystal spherical silicon nanoparticles around a generated core of a single-crystal spherical silicon nanoparticle, it is difficult to uniformly supply silicon halide necessary for growth. Hence, single-crystal spherical silicon nanoparticles are produced with a distribution of shapes. Therefore, in the production of the single-crystal spherical silicon nanoparticles of the present invention, the temperature of the single-crystal spherical silicon nanoparticle reduction liquid (Liquid A) is set to 5°C or lower in order to greatly suppress the frequency of generation of cores for production of single-crystal spherical silicon nanoparticles, thereby controlling such that the single-crystal spherical silicon nanoparticle raw material liquid (Liquid B) is uniformly supplied to the cores of single-crystal spherical silicon nanoparticles. Thus, single-crystal spherical silicon nanoparticles with a narrow particle size distribution can be produced.

The necessity of preparing the reduction liquid at low temperature is as described in [0030]. In addition to that, the storage temperature after the liquid preparation should also be kept low. This is because when the storage temperature of the reduction liquid is high and THF is used as a solvent, a reductive polymerization reaction of THF is caused by condensed aromatic compound anions. Since such a polymerization product generated due to the polymerization of a THF solvent will be included in the single-crystal spherical silicon nanoparticles produced by reduction of silicon halide, it is necessary to suppress the polymerization reaction. As a THF polymerization reaction inhibitor, BHT, which is added to suppress production of peroxide of THF, can be used.

(Suppression of production of polycrystalline silicon nanoparticles)

By using a flow reactor capable of promptly discharging a product from a reaction liquid, for example, a polyvalent silicon radical in which a halogen atom, i.e., a reduced intermediate of a reaction intermediate, is eliminated and therefore a silicon atom is in a radical state and single-crystal spherical silicon nanoparticles are not generated, thereby providing one of factors that enables suppression of production of polycrystalline silicon nanoparticles.

In the production of single-crystal spherical silicon nanoparticles, lithium chloride is produced as a by-product, for example. Since lithium chloride has high solubility in a reaction solvent, it can be easily separated from the single-crystal spherical silicon nanoparticles by centrifugation.

In a reduction reaction by a condensed aromatic compound anion, when silicon tetrachloride is used for example, a silicon atom from which a chlorine atom has been eliminated is in a radical state and therefore highly reactive. Single-crystal spherical silicon nanoparticles are produced by the progress of bonding between neighboring silicon atoms in such a radical state. At the same time, a compound in which silicon is bonded to a condensed aromatic compound is also produced as a by-product by the reaction with a condensed aromatic compound. Once a bonding of a condensed aromatic compound and a silicon atom is formed, it is not easily reduced by a condensed aromatic compound anion, producing a by-product other than single-crystal spherical silicon nanoparticles. That is, a part of silicon halide bonds with a condensed aromatic compound, producing a stable alkyl silicon halide. In this compound, since the part of the silicon bonded to a halogen atom to which an alkyl group is not bonded can be a silicon radical by a reduction liquid, halogen of alkyl silicon halide is continuously eliminated by a reducing agent, producing alkyl polysilane in which silicon radicals are bonded with each other. The polysilane production reaction does not produce silicon nanoparticles, resulting in loss. In order to prevent a reaction temperature that would lead to a loss reaction due to such an organic by-product, it is necessary to control the temperature of the reduction liquid to be 5°C or less.

The single-crystal spherical silicon nanoparticles can be isolated from the reaction liquid containing the produced single-crystal spherical silicon nanoparticles according to a conventional method. For example, ultracentrifugation or the like can be performed.

3. Applications of single-crystal spherical silicon nanoparticles

The single-crystal spherical silicon nanoparticles of the present invention can be used, for example, as a light emitting element, a light emitting material that produces fluorescence, a negative electrode of lithium ion batteries, an electrode material of solar cells, a bonding material for semiconductor devices to substrates, and the like.

EXAMPLE

Hereinafter, the present invention will be explained in more detail with reference to Examples, but the present invention is not limited only to these Examples.

(Transmission electron microscope (TEM): Preparation of a sample for TEM observation)

The single-crystal spherical silicon nanoparticles obtained in Examples and Comparative Examples were dispersed in THF in a container at a concentration of approximately 0.001%. The container containing the obtained dispersion was introduced into a glove box with an argon atmosphere, and the dispersion was dropped to a carbon support film and dried to prepare a sample for TEM observation.

(TEM observations)

For TEM observation of the single-crystal spherical silicon nanoparticles, the transmission electron microscopy JEM-2100 (JEOL Ltd.) was used. The above sample for TEM observation was used as a sample. The observation conditions were the acceleration voltage of 200 kV and the observation magnification of 10,000 times or more. The particle diameter was calculated from the distance between the largest perimeters of the single-crystal spherical silicon nanoparticles observed by TEM, and the average value (average particle diameter) was calculated from the measurement results of the particle diameters of 50 single-crystal spherical silicon nanoparticles.

(Scanning transmission electron microscopy (STEM))

An atomic resolution analytical electron microscopy JEM-ARM200F (manufactured by JEOL Ltd.) was used to observe STEM of the single-crystal spherical silicon nanoparticles. The above sample for TEM observation was used as a sample. The observation conditions were the acceleration voltage of 80 kV and the observation magnification of 50,000 times or more, and the analysis was performed using a beam diameter of 0.2 nm.

(Infrared (IR) absorbance spectrum)

The IR absorbance spectrum of the single-crystal spherical silicon nanoparticles was measured using the Fourier transform infrared spectrophotometer FT/IR-6600 (JASCO Corporation) by Attenuated total reflection (ATR) method. The measurement conditions were the resolution of 4.0 $cm^{-1}$, accumulated number of 128 times, diamond prism (PKS-D1F) (wide area): refractive index of 2.4) incorporated in ATRPRO ONE, which is an accessory of FT/IR-6600, and the incident angle of 45°. An infrared (IR) absorption spectrum measured for the single-crystal spherical silicon nanoparticles produced in Examples and for the polycrystalline silicon nanoparticles produced in Comparative Examples are referred to as the IR spectrum.

(Fluorescence spectrum)

The fluorescence spectrum of the single-crystal spherical silicon nanoparticles was measured using the spectrofluorometer FT-6500 (JASCO Corporation). As a sample, a sample liquid dispersed in THF or DME was placed in a quartz cell (optical path length: 1 cm) in a glove box with an argon atmosphere, the upper part was sealed, and then it was removed from the glove box and measured. The measurement conditions were: the excitation bandwidth of 3 nm, fluorescence bandwidth of 3nm, response of 0.1 seconds, scan rate of 100 nm/min, and data acquisition interval of 0.5nm. Similarly, the fluorescence spectrum of 9,10-diphenylanthracene as a reference substance for relative fluorescence quantum efficiency was also measured under the same conditions.

(Waveform separation of fluorescence spectrum)

The measured fluorescence spectrum of the single-crystal spherical silicon nanoparticles was waveform separated to calculate the relative fluorescence quantum efficiency to the fluorescence quantum efficiency of 9,10-diphenylanthracene, and the area percentage of the fluorescence spectrum with a peak at 430 nm was calculated. The waveform separation was performed using the built-in waveform separation software of FT/IR-6600, which was used for the IR absorption spectrum measurement.

(Relative fluorescence quantum efficiency)

The fluorescence quantum efficiency of a fluorescent substance can be evaluated by the efficiency of fluorescence generated in response to excitation light. In the present invention, the fluorescence quantum efficiency of the single-crystal spherical silicon nanoparticles was calculated as a relative value obtained by setting the fluorescence quantum efficiency of 9,10-diphenylanthracene as a reference substance as 1.0. The relative fluorescence quantum efficiency was calculated by the following equation (1).

$$\Phi_x \ = \ \Phi_s \ (F_x/F_s)(A_s/A_x)(I_s/I_x)(n_x^2/n_s^2) \ \cdots \ (1)$$

[In the equation, x represents the single-crystal spherical silicon nanoparticles. s represents 9,10-diphenylanthracene. $\Phi_x$ represents the relative fluorescence quantum efficiency of the single-crystal spherical silicon nanoparticles. $\Phi_s$ represents the quantum efficiency of 9,10-diphenylanthracene. F represents the area of the fluorescence spectrum. A represents the absorbance at the excitation wavelength. I represents the intensity of the excitation light. n represents the refractive index of a solvent used.]

According to the present invention, for 9,10-diphenylanthracene, a reference material, and the single-crystal spherical silicon nanoparticles, the measurement conditions of the spectrophotometer for measuring fluorescence, i.e., the bandpass width of excitation light, bandpass width of fluorescence, scan rate, data acquisition interval, and measurement sensitivity are all constant, and the same solvent, THF, is used. Hence, $(I_s/I_x) \ (n_x^2/n_s^2)$ in Equation (1) is 1.0. Therefore, the efficiencies were calculated based on the area of the fluorescence spectrum and the absorbance value at the time of measurement, of the THF dispersion of the single-crystal spherical silicon nanoparticles and the THF solution of 9,10-diphenylanthracene.

(ICP-OES measurement)

The concentrations of silicon and lithium in the single-crystal spherical silicon nanoparticles were measured using ICP-OES (high frequency inductively coupled plasma emission spectrometer, ICPS-8100, Shimadzu Corporation). The measurement conditions were as follows: 4 mg of the single-crystal spherical silicon nanoparticles were weighed for a sample, and dissolved in hydrofluoric acid and nitric acid; the mixture was transferred to a 25 mL volumetric flask and lithium was quantified; and then the sample solution was diluted with pure water and silicon was quantified. A calibration curve was prepared using a magnesium standard solution for atomic absorption spectrometry (Kanto Chemical Co., Ltd.) and a lithium standard solution for atomic absorption spectrometry (Kanto Chemical Co., Ltd.). An emission line of 670.784 nm was used for identification and quantification of lithium, and an emission line of 279.553 nm was used for identification and quantification of magnesium.

(Ultraviolet-visible: UV-vis absorption spectrum measurement)

The UV-vis (ultraviolet-visible) absorption spectrum of the single-crystal spherical silicon nanoparticles was measured using an ultraviolet-visible near-infrared spectrophotometer (V-770, JASCO Corporation). The measurement range was 200 nm to 900 nm, the sampling rate was 0.2 nm, and the measurement speed was low. A quartz liquid cell with a thickness of 10 mm was used for measurement. To calculate the relative fluorescence quantum efficiency of the single-crystal spherical silicon nanoparticles, they were diluted with THF such that the absorbance at wavelengths from 300 nm to 400 nm was 0.05 or less, and measurement was performed. The absorbance of the THF solution of 9,10-diphenylanthracene was measured under the same measurement conditions.

(Circularity)

Circularity was calculated as an index for evaluating the sphericity of the single-crystal spherical silicon nanoparticles as follows. For the circularity of the single-crystal spherical silicon nanoparticles, the image obtained by TEM was approximated to ellipse by using the software iTEM for TEM image (Olympus Soft Imaging Solutions, GmbH). Next, the major axis (D), perimeter (Z) and area (S) of the ellipse, a projected image of the single-crystal spherical silicon nanoparticles, were determined from the analysis results of the TEM image analysis software. By using the values of the perimeter (Z) and the area (S), $4\pi S/Z^2$ was calculated to obtain the circularity. As the circularity value is closer to 1, the particle is closer to a spherical shape. When the shape of the particle is truly spherical, the circularity is maximum 1.

In addition, an average value of the major axis (D) of the ellipse was determined and defined as the average particle diameter. The measurements were calculated for 50 independent single-crystal spherical silicon nanoparticles.

Example 1

In Example 1, single-crystal spherical silicon nanoparticles were produced by reducing a THF solution of silicon tetrachloride ($SiCl_4$), a raw material (single-crystal spherical silicon nanoparticle raw material liquid), with a naphthalene-dissolved THF solution of metal lithium (single-crystal spherical silicon nanoparticle reduction liquid).

Table 1 shows the formulations of Example 1-1 to Example 1-4. The solvent used in Example 1 is super dehydrated tetrahydrofuran with a residual water content of 10 ppm or less (FUJIFILM Wako Pure Chemical Corporation) which contains 2,6-di-tert-butyl-4-methylphenol as a polymerization inhibitor. A single-crystal spherical silicon nanoparticle reduction liquid (Liquid A) and a single-crystal spherical silicon nanoparticle raw material liquid (Liquid B) were prepared in a glove box with an argon atmosphere. Specifically, Liquid A, the single-crystal spherical silicon nanoparticle reduction liquid, was prepared at a preparation temperature of -20°C by dissolving metal lithium in a THF solution in which naphthalene had been dissolved at a concentration of 0.4 mol/L with a glass-coated magnetic stirrer such that the concentration of metal lithium became 0.4 mol/L. Similarly, silicon tetrachloride, a single-crystal spherical silicon nanoparticle raw material of Liquid B, was dissolved in THF, and then stirred for at least 60 minutes with a glass-coated magnetic stirrer. Regarding the substances indicated by chemical formulas or abbreviations in Table 1, $SiCl_4$ is silicon tetrachloride (Tokyo Chemical Industry Co., Ltd.), Li is metal lithium (Kishida Chemical Co., Ltd.), and C10H8 is naphthalene (Kanto Chemical Co., Ltd.).

[Table 1]

| | First fluid (Liquid A) (Single-crystal spherical silicon nanoparticle reduction liquid) | | | | Second fluid (Liquid B) (Single-crystal spherical silicon nanoparticle raw material liquid) | |
|---|---|---|---|---|---|---|
| | Raw material | [mol/L] | Raw material | [mol/L] | Raw material | [mol/L] |
| Example 1-1 to Example 1-4 | Li | 0.4 | $C_{10}H_8$ | 0.4 | $SiCl_4$ | 0.1 |

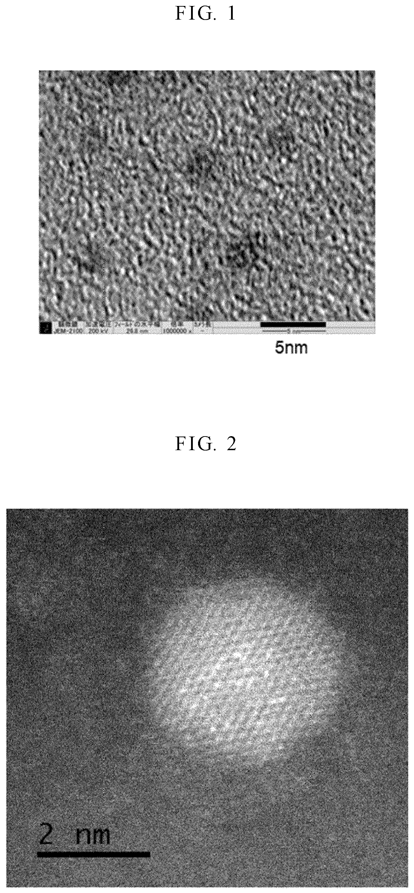

Next, the prepared single-crystal spherical silicon nanoparticle reduction liquid (Liquid A) and single-crystal spherical silicon nanoparticle raw material liquid (Liquid B) were mixed using the fluid processing apparatus described in Patent Literature 5 by the applicant of the present application. Here, the fluid processing apparatus described in Patent Literature 5 is the apparatus described in FIG. 1(A) of Patent Literature 5 which has a concentric circular ring shape surrounding the central opening of the processing surface 2 which is a ring shape disk wherein the opening d20 of the second introduction part is formed in a ring shape. Specifically, Liquid A was introduced between the processing surfaces 1 and 2 from the first introduction part d1, and while the processing part 10 was operated at a rotation speed of 700 rpm to 5000 rpm, Liquid B was introduced between the surfaces 1 and 2 from the second introduction part d2 to mix the single-crystal spherical silicon nanoparticle raw material liquid and the single-crystal spherical silicon nanoparticle reduction liquid in a thin film fluid, and the single-crystal spherical silicon nanoparticles were precipitated between the processing surfaces 1 and 2. The discharge liquid containing the single-crystal spherical silicon nanoparticles was discharged from between the processing surfaces 1 and 2 of the fluid processing apparatus. The discharged single-crystal spherical silicon nanoparticle dispersion was recovered in a beaker through the vessel.

Table 2 shows the operation conditions of the fluid processing apparatus in Example 1. The introduction temperature (liquid sending temperature) and introduction pressure (liquid sending pressure) of Liquid A and Liquid B shown in Table 2 were measured using a thermometer and a pressure gauge provided in the sealed introduction paths (the first introduction part d1 and the second introduction part d2) between the processing surfaces 1 and 2. The introduction temperature of Liquid A shown in Table 2 was the actual temperature of Liquid A in the first introduction part d1 under the introduction pressure. The introduction temperature of Liquid B was the actual temperature of Liquid B in the second introduction part d2 under the introduction pressure.

[Table 2]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
| --- | --- | --- | --- | --- | --- | --- | --- |
| | | Liquid A | Liquid B | Liquid A | Liquid B | Liquid A | Liquid B |
| Example 1-1 | 700 | 10 | 10 | 5 | 15 | <0.1 | <0.1 |
| Example 1-2 | 2100 | 10 | 10 | 5 | 15 | <0.1 | <0.1 |
| Example 1-3 | 3500 | 10 | 10 | 5 | 15 | <0.1 | <0.1 |
| Example 1-4 | 5000 | 10 | 10 | 5 | 15 | <0.1 | <0.1 |

A wet cake sample was prepared from the single-crystal spherical silicon nanoparticle dispersion discharged from the fluid processing apparatus and recovered in a beaker. The preparation method was performed according to a conventional method. The discharged single-crystal spherical silicon nanoparticle dispersion was recovered, the single-crystal spherical silicon nanoparticles were sedimented from the recovered liquid by centrifugation (1,000,000G, 4 hours), and the supernatant was removed. After the removal, ultrasonic washing with THF and sedimentation were repeated, and the finally obtained single-crystal spherical silicon nanoparticles were used as a wet cake sample. A part of the wet cake was dried at -0.10 MPaG at 25°C for 20 hours to obtain a dry powder sample.

FIG. 1 shows the TEM image of the single-crystal spherical silicon nanoparticles of Example 1-1. Similar results were confirmed for the single-crystal spherical silicon nanoparticles of Example 1-2 to Example 1-4.

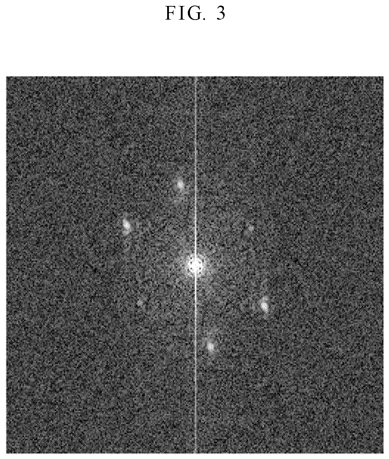

FIG. 2 shows the STEM image of the single-crystal spherical silicon nanoparticles of Example 1-4. FIG. 3 shows the Fourier-transformed electron diffraction pattern of the STEM image. For the single-crystal spherical silicon nanoparticles of Example 1-1 to Example 1-3, an interference image by similar electron beams on silicon crystal lattice planes in a particle and an electron beam diffraction pattern of a dot pattern, which is seen in the case of a single crystal, were confirmed. Therefore, it was confirmed that the single-crystal spherical silicon nanoparticles produced in Example 1 were monocrystalline. The grating face interval calculated from the obtained electron beam diffraction pattern was 0.162 nm, and it was confirmed that it was an electron beam diffraction pattern from (311) face of crystalline silicon.

(Si-H bond)

FIG. 4 shows the IR measurement result of the single-crystal spherical silicon nanoparticles of Example 1-2 in the wavenumber range of 1800 cm$^{-1}$ to 2300 cm$^{-1}$. Since the absorption at 2105 cm$^{-1}$ is attributed to stretching vibration of Si-H bond, it was confirmed that the surface of the single-crystal spherical silicon nanoparticles was hydrogenated. Example 1-1, Example 1-3, and Example 1-4 were also confirmed in the same manner. Since Si-H bond can make the surface of single-crystal spherical silicon nanoparticles hydrophobic, it was confirmed that the single-crystal spherical silicon nanoparticles can be well dispersed in an organic solvent. As shown in FIG. 1, it was observed that the single-crystal spherical silicon nanoparticles of the present invention were dispersed even at an extremely small distance of around 5 nm.

(Si-O bond)

FIG. 5a shows the IR spectrum in the wavenumber range of 900 $cm^{-1}$ to 1300 $cm^{-1}$. For the single-crystal spherical silicon nanoparticles of Example 1-4, an absorption maximum was confirmed at 1095 $cm^{-1}$. This absorption peak wavenumber coincides with the absorption peak wavenumber of 1095 $cm^{-1}$ of amorphous silica ($SiO_2$) as a reagent. For comparison, the IR spectrum of a single-crystal silicon wafer is shown. The absorption maximum of the wafer was confirmed at a wavenumber of 1105 $cm^{-1}$, and this was absorption occurred in a state where oxygen was contained between silicon crystal lattices as solid solution.

FIG. 5b shows the IR spectrum in the wavenumber range of 400 $cm^{-1}$ to 550 $cm^{-1}$. For the single-crystal spherical silicon nanoparticles of Example 1-4, any absorption peak with a distinct maximum was not observed, but for the reagent amorphous silica ($SiO_2$), a maximum absorption peak was observed at 460 $cm^{-1}$. This means that, when the commonly known peak near 1100 $cm^{-1}$, which is generally thought to be due to Si-O bond, and the peak exhibited by amorphous silica ($SiO_2$) at 460 $cm^{-1}$ are observed at the same time, the substance is regarded as oxidized $SiO_2$.

(Solid solution oxygen in silicon crystal)

According to the IR spectra shown in Fig. 5a and Fig. 5b, absorption peaks at the above two locations required for being regarded as $SiO_2$ were not confirmed at the same time in the IR spectrum of the single-crystal spherical silicon nanoparticles of Example 1-4. Therefore, it is considered that due to various states of solid solution oxygen in silicon crystal, the absorption at 1095 $cm^{-1}$ was measured off from 1105 $cm^{-1}$, which is the absorption peak wavenumber due to solid solution oxygen, by 10 $cm^{-1}$, with a wider spectral width. Since the single-crystal spherical silicon nanoparticles of Example 1-4 exhibited a fluorescence spectrum, it is confirmed that they are silicon crystals. Furthermore, it is desirable that the presence of oxygen that can bond with a silicon atom in silicon crystal be as small as possible. It is desirable that the ratio: B/A is less than 0.2, where A is the peak intensity of the maximum peak observed in the wavenumber range of 1000 $cm^{-1}$ to 1200 $cm^{-1}$, and B is the peak intensity of the maximum peak observed in the wavenumber range of 400 $cm^{-1}$ to 500 $cm^{-1}$ in the IR spectrum. In Example 1-4, the ratio: B/A is 0.1, which is less than 0.2. To the contrary, the reagent amorphous silica ($SiO_2$) exhibits the maximum peak at the peak wavenumber of 460 $cm^{-1}$, and the ratio: B/A is 0.4, which exceeds 0.2.

(Si-Cl bond)

FIG. 5c shows the result of a study of Si-Cl bond, in which a silicon atom and a chlorine atom are bonded. When Si-Cl bond exists, absorption with a wavenumber that varies depending on the number of chlorine atoms bonded to silicon atoms is observed in the wavenumber range of 530 $cm^{-1}$ to 630 $cm^{-1}$ in the IR spectrum. Si-Cl bond is likely to be hydrolyzed by atmospheric moisture and lead to production of silicon oxide or hydroxide. Hence, it is desirable to reduce the number of Si-Cl bonds as much as possible. As for the ratio of Si-Cl bond, it is desirable that the ratio: C/A is less than 0.2, where A is the peak intensity of the maximum peak observed in the wavenumber range of 1000 $cm^{-1}$ to 1200 $cm^{-1}$ and C is the peak intensity of the maximum peak in the wavenumber range of 530 $cm^{-1}$ to 630 $cm^{-1}$. In the case of the ratio: C/A less than 0.2, even when single-crystal spherical silicon nanoparticles were taken out into the atmosphere, it was not observed that the nanoparticles immediately changed color or changed to silicon oxide or silicon hydroxide. In Example 1-4, the ratio: C/A is 0.06, which is less than 0.2. Similar results were also obtained in Example 1-1 to Example 1-3.

(Substituted carbon in silicon crystal)

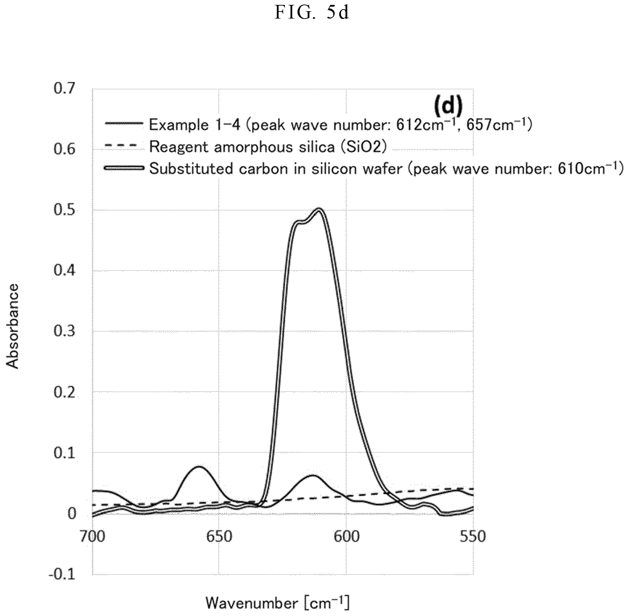

FIG. 5d shows the IR spectrum in the wavenumber range of 550 $cm^{-1}$ to 700 $cm^{-1}$. It is known that absorption due to substitution of a silicon atom with a carbon atom in silicon crystal occurs in this range. Therefore, the wavenumber range of the absorption due to Si-C bond overlaps with the range of 530 $cm^{-1}$ to 630 $cm^{-1}$ of the absorption due to Si-Cl bond described in the previous paragraph. In Example 1-4, the absorption at the wavenumber of 612 $cm^{-1}$ was explained to be due to Si-Cl bond. Even if the absorption at the wavenumber of 612 $cm^{-1}$ is due to Si-C bond due to solid solution carbon atoms, the carbon concentration is lower than that of the silicon wafer because the ratio: C/A in Example 1-4 is 0.06, which is lower as compared with the ratio: C/A of 0.5 based on the wavenumber of 610 $cm^{-1}$ confirmed for the silicon wafer. Since the single-crystal spherical silicon nanoparticles of the present invention are produced by reducing silicon halide with a reduction liquid containing an aromatic compound, it was expected that carbon would be contained in single-crystal spherical silicon nanoparticles as an impurity. However, the single-crystal spherical silicon particles of the present invention contain almost no carbon atoms, and are therefore highly pure. Since the absorption wavenumber due to Si-C bond and the absorption wavenumber due to Si-Cl bond overlap, it cannot be unmistakably determined whether the absorption at 612 $cm^{-1}$ is due to Si-C bond or Si-Cl bond. Still, the single-crystal spherical silicon nanoparticles of Example 1-4 are single-crystal spherical silicon nanoparticles with low concentrations of carbon and chlorine.

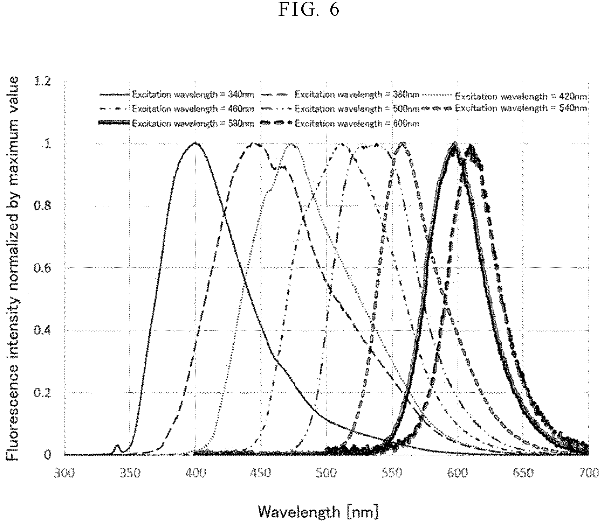

FIG. 6 shows fluorescence spectra of the single-crystal spherical silicon nanoparticles of Example 1-3. These are fluorescence spectra normalized by setting the maximum intensity of the fluorescence spectrum obtained for each excitation wavelength to 1.0 and are the results of changing the excitation wavelength from 340 nm to 600 nm in steps of 40 nm. From the results in FIG. 6, it was confirmed that the fluorescence of the single-crystal spherical silicon nanoparticles of Example 1-3 showed maximum peaks in the range of 400 nm to 610 nm depending on the excitation wavelength.

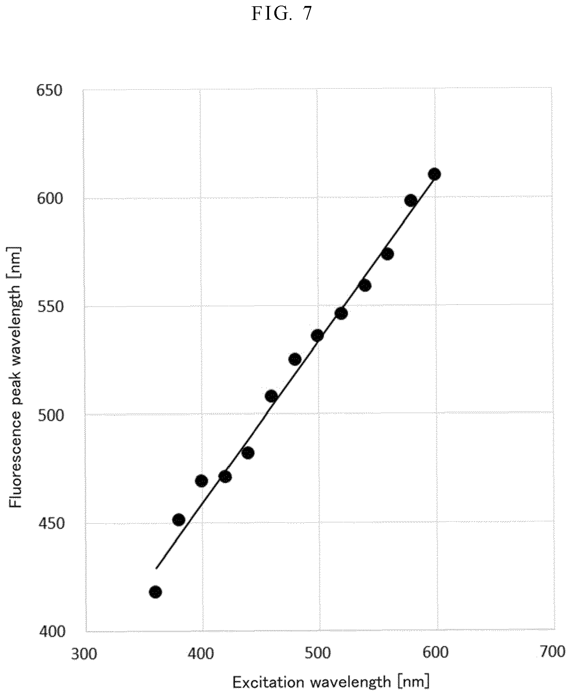

FIG. 7 was created based on the results of FIG. 6 and shows excitation wavelength dependence of the fluorescence peak wavelength of the single-crystal spherical silicon nanoparticles of Example 1-3. Since it is known that as the particle diameter of silicon nanoparticles increases, the fluorescence peak wavelength shifts to the longer wavelength side, it was confirmed that fluorescence from the nanoparticles reflecting the particle size distribution of the single-crystal spherical silicon nanoparticles was obtained.

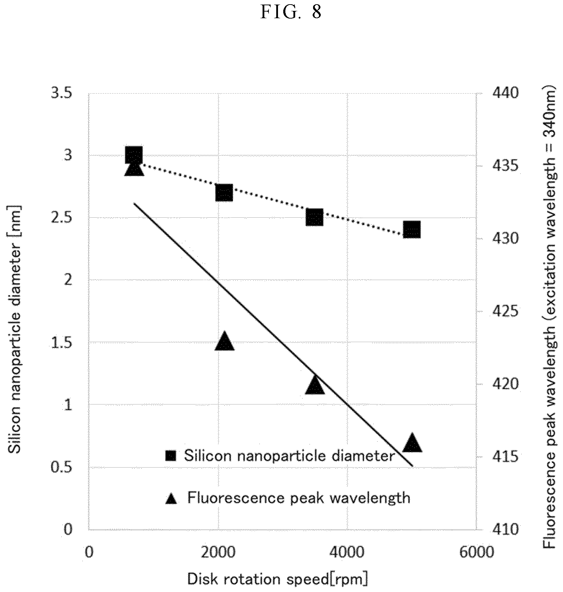

FIG. 8 shows measurement results of the particle diameter and the fluorescence peak wavelength relative to the disk rotation speed of the single-crystal spherical silicon nanoparticles of Example 1-1 to Example 1-4. It was confirmed that the particle diameter of the single-crystal spherical silicon nanoparticles decreased as the disk rotation speed increased. Therefore, it was confirmed that the particle diameter of single-crystal spherical silicon nanoparticles could be controlled by the disk rotation speed. In addition, it was confirmed that the fluorescence peak wavelength shifted to the shorter wavelength side as the disk rotation speed increased, that is, as the silicon nanoparticle diameter decreased. This change in fluorescence peak wavelength due to particle diameter is explained by (A) quantum effect of the three mechanisms (A) to (C) above. That is, it is thought that the fluorescence peak wavelength of silicon nanoparticles shifted to the longer wavelength side because the band gap of the silicon nanoparticles increased as the particle diameter of the silicon nanoparticles decreased. This was a result of (A) quantum effect mechanism. Since the silicon nanoparticles of the present invention are not surface modified with an alkyl group or an amino group and (B) surface modification mechanism of the above three mechanisms is not applicable, it is thought that (C) oxygen mediated mechanism due to the solid solution oxygen in silicon crystal acts synergistically with (A) quantum effect mechanism.

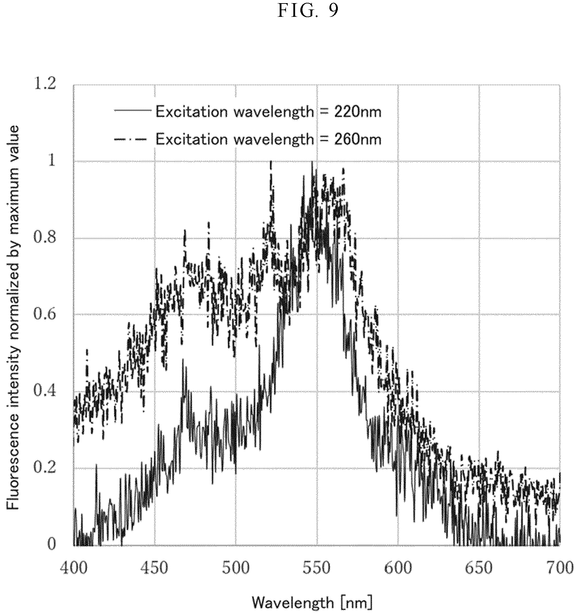

FIG. 9 shows the visible light fluorescence spectrum of the single-crystal spherical silicon nanoparticles of Example 1-2 at deep ultraviolet wavelengths. Deep ultraviolet light refers to light in the wavelength range of 200 nm to 300 nm. In addition to the fluorescence spectra upon excitation by visible light shown in FIG. 6, it was confirmed that visible light fluorescence in the wavelength range of 400 nm to 600 nm with fluorescence peaks at 470 nm and 550 nm could also be obtained by short-wavelength deep ultraviolet light. Similar results were obtained in Example 1-1, Example 1-3, and Example 1-4. Thus, since visible light fluorescence can be obtained by light in a wide wavelength range from deep ultraviolet light to visible light, it was confirmed that the single-crystal spherical silicon nanoparticles of the present invention have a wider range of applications in which fluorescence thereof can be used.

It was confirmed that the lithium concentration of the single-crystal spherical silicon nanoparticles of Example 1-1 to Example 1-4 measured by ICP-OES was less than 1 ppm. From this, it was confirmed that the single-crystal spherical silicon nanoparticles of the present invention did not take in metal lithium contained in the single-crystal spherical silicon nanoparticle reduction liquid and had high purity.

Table 3 shows the average particle diameter, the circularity, the relative fluorescence quantum efficiency as well as the ratio: B/A and the ratio: C obtained from the IR spectra, of the single-crystal spherical silicon nanoparticles of Example 1-1 to Example 1-4. The single-crystal spherical silicon nanoparticles of Example 1-1 to Example 1-4 have the ratio: B/A of 0.08 to 0.10 and the ratio of C/A of 0.06 to 0.08, which are both less than 0.2.

[Table 3]

|  | Average particle diameter [nm] | Circularity | Relative fluorescence quantum efficiency [%] | B/A | C/A |
|---|---|---|---|---|---|
| Example 1-1 | 3.1 | 0.93 | 11 | 0.10 | 0.06 |
| Example 1-2 | 2.7 | 0.95 | 13 | 0.09 | 0.07 |
| Example 1-3 | 2.5 | 0.95 | 13 | 0.08 | 0.08 |
| Example 1-4 | 2.5 | 0.95 | 13 | 0.10 | 0.06 |

Example 2

In Example 2, silicon tetrabromide ($SiBr_4$) was used in place of silicon tetrachloride ($SiCl_4$) used in Example 1, and single-crystal spherical silicon nanoparticles were produced by reducing a THF solution of silicon tetrabromide (single-crystal spherical silicon nanoparticle raw material liquid) with a naphthalene-dissolved THF solution of metal lithium (single-crystal spherical silicon nanoparticle reduction liquid).

Table 4 shows the formulations of Example 2-1 to Example 2-4. The solvent used in Example 2 is super dehydrated tetrahydrofuran with a residual water content of 10 ppm or less (FUJIFILM Wako Pure Chemical Corporation), which is the same as in Example 1. In the same manner as in Example 1, a single-crystal spherical silicon nanoparticle reduction liquid (Liquid A) and a single-crystal spherical silicon nanoparticle raw material liquid (Liquid B) were prepared in a glove box with an argon atmosphere.

[Table 4]

| | First fluid (Liquid A) (Single-crystal spherical silicon nanoparticle reduction liquid) | | | | Second fluid (Liquid B) (Single-crystal spherical silicon nanoparticle raw material liquid) | |
|---|---|---|---|---|---|---|
| | Raw material | [mol/L] | Raw material | [mol/L] | Raw material | [mol/L] |
| Example 2-1 to Example 2-4 | Li | 0.4 | $C_{10}H_8$ | 0.4 | $SiBr_4$ | 0.1 |

Next, in the same manner as in Example 1, the prepared single-crystal spherical silicon nanoparticle reduction liquid (Liquid A) and single-crystal spherical silicon nanoparticle raw material liquid (Liquid B) were mixed using the fluid processing apparatus described in Patent Literature 5 by the applicant of the present application. Table 5 shows the operation conditions of the fluid processing apparatus.

[Table 5]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
| | | Liquid A | Liquid B | Liquid A | Liquid B | Liquid A | Liquid B |
| Example 2-1 | 700 | 10 | 10 | 5 | 15 | <0.1 | <0.1 |
| Example 2-2 | 2100 | 10 | 10 | 5 | 15 | <0.1 | <0.1 |
| Example 2-3 | 3500 | 10 | 10 | 5 | 15 | <0.1 | <0.1 |
| Example 2-4 | 5000 | 10 | 10 | 5 | 15 | <0.1 | <0.1 |

A dry powder sample and a wet cake sample were prepared from the single-crystal spherical silicon nanoparticle dispersion discharged from the fluid processing apparatus and recovered in a beaker. The preparation method was according to a conventional method. The discharged single-crystal spherical silicon nanoparticle dispersion was recovered, the single-crystal spherical silicon nanoparticles were sedimented from the recovered liquid by centrifugation (1,000,000G, 4 hours), and the supernatant was removed. After the removal, ultrasonic washing with THF and sedimentation were repeated, and a part of the wet cake of the finally obtained single-crystal spherical silicon nanoparticles was dried at -0.10 MPaG at 25°C for 20 hours to obtain a dry powder sample. The remainder was used as a wet cake sample.

Table 6 shows the average particle diameter, the circularity, the relative fluorescence quantum efficiency as well as the ratio: B/A and the ratio: C/A obtained from the IR spectra, of the single-crystal spherical silicon nanoparticles of Example 2-1 to Example 2-4. The single-crystal spherical silicon nanoparticles of Example 2-1 to Example 2-4 have the ratio: B/A of 0.09 or 0.10 and the ratio of C/A of 0.06 to 0.08, which are both less than 0.2.

[Table 6]

| | Average particle diameter [nm] | Circularity | Relative fluorescence quantum efficiency [%] | B/A | C/A |
|---|---|---|---|---|---|
| Example 2-1 | 3.2 | 0.93 | 11 | 0.09 | 0.06 |
| Example 2-2 | 2.8 | 0.94 | 12 | 0.10 | 0.08 |
| Example 2-3 | 2.8 | 0.94 | 12 | 0.10 | 0.08 |
| Example 2-4 | 2.7 | 0.95 | 12 | 0.09 | 0.07 |

Comparative Example 1

In Comparative Example 1, in accordance with Example 6 of Patent Literature 5, single-crystal spherical silicon nanoparticles were produced by reducing a THF solution of silicon tetrachloride (silicon nanoparticle raw material liquid) with a DBB (4,4'-di-tert-butylbiphenyl)-dissolved THF solution of metal lithium (silicon nanoparticle reduction liquid).

Table 7 shows the formulations of Comparative Example 1-1 to Example 1-3. The THF used in Comparative Example 1 is super dehydrated tetrahydrofuran with a residual water content of 10 ppm or less (FUJIFILM Wako Pure Chemical Corporation), which is the same as in Example 1. A silicon nanoparticle reduction liquid (Liquid A) and a silicon nanoparticle raw material liquid (Liquid B) were prepared in a glove box with an argon atmosphere. Specifically, Liquid A, the silicon nanoparticle reduction liquid was prepared at room temperature of 16°C to 17°C by measuring 30 mmol of metal lithium in a flask in advance, pouring 200 mL of the THF solution in which 40 mmol of DBB had been dissolved in the flask, and dissolving the metal lithium with a glass-coated magnetic stirrer. Similarly, silicon tetrachloride, a silicon nanoparticle raw material for Liquid B, was dissolved in THF, and then stirred for at least 60 minutes with a glass-coated magnetic stirrer. Regarding the substances indicated by chemical formulas or abbreviations in Table 7, $SiCl_4$ is silicon tetrachloride (Tokyo Chemical Industry Co., Ltd.), Li is metal lithium (Kishida Chemical Co., Ltd.), C10H8 is naphthalene (Kanto Chemical Co., Ltd.), and DBB is 4,4'-di-tert-butylbiphenyl (manufactured by Tokyo Chemical Industry Co., Ltd.).

[Table 7]

| | First fluid (Liquid A) (Silicon nanoparticle reduction liquid) | | | | Second fluid (Liquid B) (Silicon nanoparticle raw material liquid) | |
|---|---|---|---|---|---|---|
| | Raw material | [mol/L] | Raw material | [mol/L] | Raw material | [mol/L] |
| Comparative Example 1-1 to Comparative Example 1-3 | Li | 0.15 | DBB | 0.2 | $SiCl_4$ | 0.05 |

Next, in the same manner as in Example 1, the prepared silicon nanoparticle reduction liquid (Liquid A) and silicon nanoparticle raw material liquid (Liquid B) were mixed using the fluid processing apparatus described in Patent Literature 5 by the applicant of the present application. Table 8 shows the operation conditions of the fluid processing apparatus in Comparative Example 1-1 to Comparative Example 1-3.

[Table 8]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
| | | Liquid A | Liquid B | Liquid A | Liquid B | Liquid A | Liquid B |
| Comparative Example 1-1 | 500 | 10 | 10 | -35 | 15 | <0.1 | <0.1 |
| Comparative Example 1-2 | 700 | 10 | 10 | -35 | 15 | <0.1 | <0.1 |
| Comparative Example 1-3 | 2100 | 10 | 10 | -35 | 15 | <0.1 | <0.1 |

(Preparation of hexyl group-terminated silicon nanoparticles)

Next, the silicon nanoparticle dispersion discharged and recovered from the fluid processing apparatus was subjected to the surface stabilization treatment described in Example 6 of Patent Literature 5. Specifically, 10 mL of the silicon nanoparticle dispersion was put in a 100 mL three-necked flask in a glove box with an argon atmosphere, and the flask was kept in a cooling tank maintained at -3°C using IPA as a coolant. After connecting a three-way cock to the three-necked flask to allow argon to pass therethrough, a solution containing hexylmagnesium bromide (manufactured by Tokyo Chemical Industry Co., Ltd.) at a concentration of four times the molar concentration of silicon in the silicon nanoparticle dispersion was added dropwise to the discharge liquid using a glass syringe with a metal needle passing through a rubber septum of the three-necked flask. After the dropwise addition, the cooling tank was removed, the temperature was gradually raised to room temperature of 16°C to 17°C, and the mixture was stirred for 24 hours under an argon atmosphere. Thereby, silicon nanoparticles whose surface of chlorinated silicon nanoparticles dispersed in the discharge liquid was terminated with a hexyl group were obtained. In order to purify the hexyl group-terminated silicon nanoparticles, hexane was added to the flask, and the hexyl group-terminated silicon nanoparticles dispersed in the THF solution were extracted into a hexane layer. After separating the hexane layer from the solution, pure water was added to the hexane layer to dissolve and wash a reaction product such as lithium chloride and a residue caused by hexylmagnesium bromide.

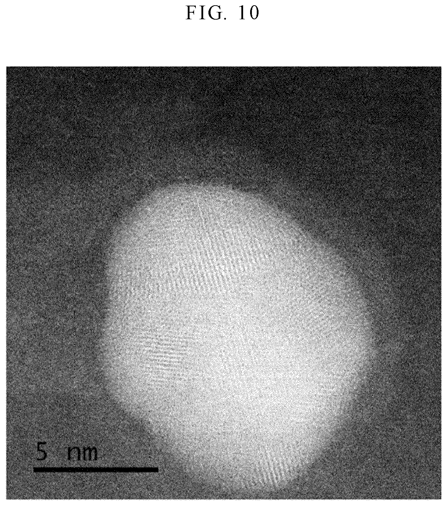

FIG. 10 shows the STEM image of the hexyl group-terminated silicon nanoparticles prepared Comparative Example 1-1. According to the STEM image, although the hexyl group-terminated silicon particles were crystals, it was observed that the lattice planes therein were not aligned in a certain direction, and it was confirmed that the hexyl group-terminated silicon particles were polycrystals with intersecting lattice planes.

In addition, unlike in Example 1, it was confirmed that the silicon nanoparticles were not spherical but had a distorted particle shape. As shown in Table 9, the circularity of the hexyl group-terminated silicon nanoparticles of Comparative Example 1-1 to Comparative Example 1-3 was 0.83 or 0.84, not 0.9 or more.

The following reasons can be considered as the reason why the silicon particles became polycrystals.

In Example 1 of the present invention, the single-crystal spherical silicon nanoparticle reduction liquid was prepared at a temperature of -20°C, but in Comparative Example 1, it was prepared at a room temperature of 16°C to 17°C. This was to match Example 1 of Patent Literature 4 and Example 6 of Patent Literature 5, in which the reduction liquid was prepared from metal lithium and DBB at room temperature. As a result of the preparation of the reduction liquid at room temperature, in the reaction in which metal lithium releases an electron to be dissolved in THF, an equilibrium reaction occurs in which DBB anions (radical anions), which are produced by a transfer of one electron of metal lithium to a DBB molecule, produce DBB dianions and uncharged DBB molecules through a disproportionation reaction, resulting in a lower concentration of DBB anions. Thus, it is thought that the coexistence of various molecular species in the THF solution inhibited spheroidization by uniform crystal growth from silicon tetrachloride to silicon nanoparticles and a distribution of reaction rates caused polycrystallization of silicon particles.

(Liquid sending temperature of reduction liquid)

A DBB anion is produced by a transfer of an electron generated when metal lithium is dissolved in THF as a lithium ion to DBB. In THF, a DBB anion and a lithium ion can exist with THF therebetween, but when the temperature during the liquid preparation is 0°C or more, a DBB anion can form an ionic bond directly with a lithium ion with no THF therebetween. Once a DBB anion and a lithium ion are ionically bonded, it is difficult for THF to intervene between the DBB anion and the lithium ion even if the liquid sending temperature at the time of producing silicon nanoparticles is set low. When a lithium ion and a DBB anion are in a direct ionic bond, a reverse electron transfer from a DBB anion to a lithium ion is likely to occur. It is thought that this caused variations in reducing power of silicon nanoparticles and non-uniformity of the crystal growth rate of silicon particles, so that the shape of the obtained silicon particles was deviated significantly from a spherical shape, resulting in the silicon particles becoming polycrystalline, not monocrystalline.

Furthermore, in Comparative Example 1, a chlorine atom was in a state of being bonded to the surface of silicon nanoparticles in order to be subjected to surface stabilization treatment with a hexyl group. Therefore, the number of moles of metal lithium, a reducing agent, was set to 3/4 times the number of moles of silicon tetrachloride. This was to match the molar ratio of the metal lithium in Example 1 of Patent Literature 4 and Example 6 of Patent Literature 5. The silicon nanoparticles before the surface stabilization treatment differ from the single-crystal spherical silicon nanoparticles of the present invention in that the surface is intentionally chlorinated. Further, after the surface stabilization treatment, a chlorine atom that was not replaced by a hexyl group remains on the surface of the silicon nanoparticles. It is assumed that such chlorine atoms undergo hydrolysis during the washing with pure water after the extraction with hexane to change the shape of the silicon nanoparticles. Similar results were confirmed for the silicon nanoparticles of Comparative Example 1-2 and Comparative Example 1-3.

(Si-H bond of polycrystalline silicon nanoparticles of Comparative Example 1)

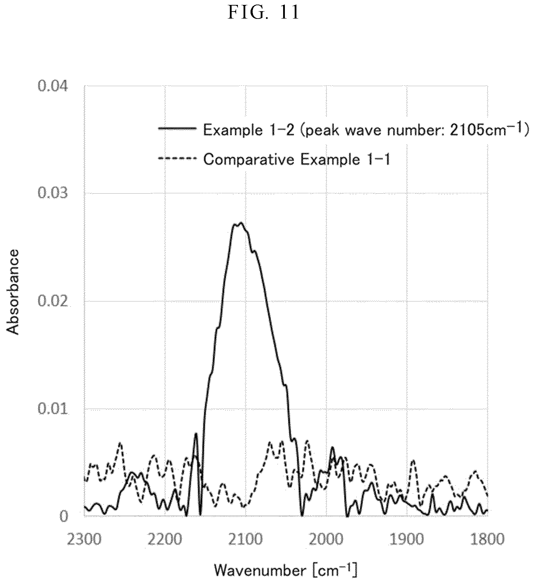

FIG. 11 shows the IR spectrum of the polycrystalline silicon nanoparticles of Comparative Example 1-1 in the wavenumber range of 1800 cm$^{-1}$ to 2300 cm$^{-1}$. In Comparative Example 1-1, the absorption peak due to Si-H bond near 2100 cm$^{-1}$ confirmed in Example 1-2 was not observed. It is thought that this was because the polycrystalline silicon nanoparticles of Comparative Example 1-1 to Comparative Example 1-3 were produced by producing chlorinated polycrystalline silicon nanoparticles in such a manner that the number of moles of metal lithium in the reduction liquid was set to 3/4 of the concentration of the metal lithium raw material in the silicon nanoparticle raw material liquid such that chlorine could remain on the surface of the polycrystalline silicon nanoparticles, and then replacing the chlorine atoms with hexyl groups using hexylmagnesium bromide.

(Si-O bond of polycrystalline silicon nanoparticles of Comparative Example 1)

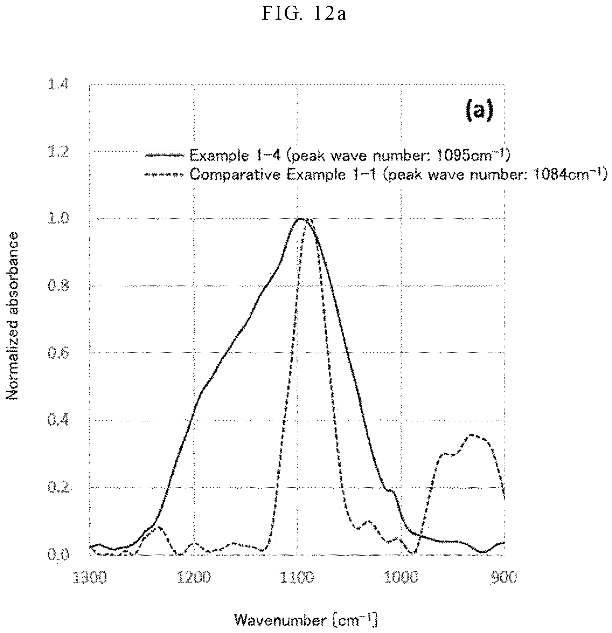

FIG. 12a and FIG. 12b show the IR spectra of the polycrystalline silicon nanoparticles of Comparative Example 1-1. In Example 1-4, an absorption peak with a wide spectrum width was observed at 1095 cm$^{-1}$, but in Comparative Example 1-1, an absorption peak with a narrow spectral width was observed at 1084 cm$^{-1}$. In addition, in Comparative Example 1-1, an absorption peak was also observed at 450 cm$^{-1}$ on the low wavenumber side. The ratio: B/A is 0.38, not less than 0.2, where A is the peak intensity of the maximum peak observed in the wavenumber range of 1000 cm$^{-1}$ to 1200 cm$^{-1}$ and B is the peak intensity of the maximum peak observed in the wavenumber range of 400 cm$^{-1}$ to 500 cm$^{-1}$ in the IR spectrum. From this result, it was confirmed that the state of Si-O bond of the polycrystalline silicon nanoparticles of Comparative Example 1-1 was different from that of the single-crystal spherical silicon nanoparticles of Example 1-4. Comparative Example 1-2 and Comparative Example 1-3 also showed similar results as Comparative Example 1-1.

(Si-Cl bond of polycrystalline silicon nanoparticles of Comparative Example 1)

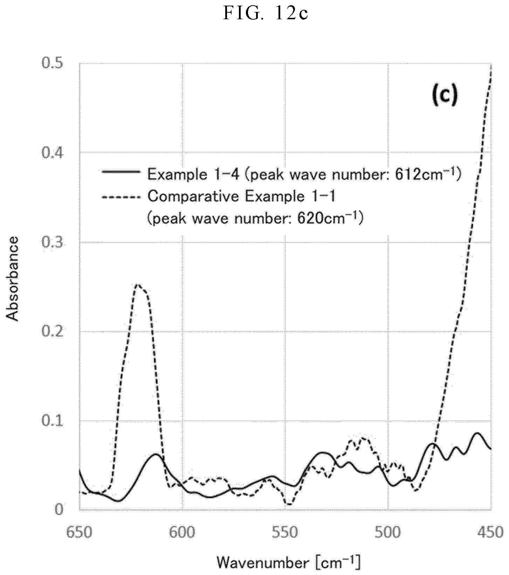

FIG. 12c shows the IR spectrum of the polycrystalline silicon nanoparticles of Comparative Example 1-1 in the wavenumber range of 450 cm$^{-1}$ to 650 cm$^{-1}$. Unlike the single-crystal spherical silicon nanoparticles of Example 1-4, a distinct maximum absorption peak was observed at 620 cm$^{-1}$, thereby confirming the presence of Si-Cl bond. The ratio: C/A is 0.25, not less than 0.2, where A is the peak intensity of the maximum peak observed in the wavenumber range of 1000 cm$^{-1}$ to 1200 cm$^{-1}$ and C is the peak intensity of the maximum peak observed in the wavenumber range of 530 cm$^{-1}$ to 630 cm$^{-1}$ in the IR spectrum. Comparative Example 1-2 and Comparative Example 1-3 also showed similar results as Comparative Example 1-1. Accordingly, it is assumed that chlorine atoms which could not be completely replaced with hexyl groups even by the surface stabilization treatment with hexylmagnesium bromide were present on the surface of the chlorinated polycrystalline silicon nanoparticles.

(Substituted carbon in polycrystalline silicon nanoparticles of Comparative Example 1)

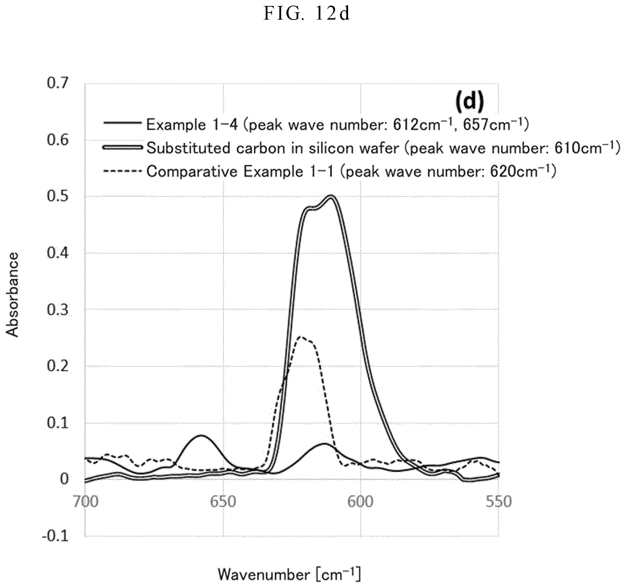

FIG. 12d shows the IR spectrum of the polycrystalline silicon nanoparticles of Comparative Example 1-1 in the wavenumber range of 550 cm$^{-1}$ to 700 cm$^{-1}$. Unlike the single-crystal spherical silicon nanoparticles of Example 1-4, an absorption peak with an absorbance of 0.25 was observed at 620 cm$^{-1}$. As described in [0088], this wavenumber range overlaps with the range of 530 cm$^{-1}$ to 630 cm$^{-1}$ in which absorption occurs even when a silicon atom formed a bond with a chlorine atom. As described above, the ratio: C/A is 0.25, not less than 0.2. This result shows that Si-Cl bond or substituted carbon exist in the polycrystalline silicon nanoparticles of Comparative Example 1-1, and it was confirmed that the composition thereof was different from that of the single-crystal spherical silicon nanoparticles of Example 1-4.

(Fluorescence spectrum of polycrystalline silicon nanoparticles of Comparative Example 1)

It was confirmed that the polycrystalline silicon nanoparticles of Comparative Example 1-1 exhibited maximum fluorescence in the wavelength range of 400 nm to 600 nm. However, as shown in FIG. 13a and FIG. 13b, it was confirmed that the fluorescence spectrum of the polycrystalline silicon nanoparticles of Comparative Example 1-1 by deep ultraviolet light with an excitation light wavelength of 300 nm or less showed a fluorescence peak at a wavelength of 400 nm or less, and it was observed that the fluorescence spectra of the polycrystalline silicon nanoparticles of Comparative Example 1-2 and Comparative Example 1-3 upon excitation by deep ultraviolet light similarly showed a peak at 400 nm or less. These results were different from the results in Example 1-4 in which the fluorescence peak wavelength was 547 nm for excitation wavelength of 220 nm and the fluorescence peak was 568 nm for excitation wavelength of 260 nm. Since the fluorescence peak wavelengths due to excitation by deep ultraviolet light of the polycrystalline silicon nanoparticles in Comparative Example 1-1 to Comparative Example 1-3 were all 400 nm or less, it was confirmed that the polycrystalline silicon nanoparticles had an electron energy structure different from that of the single-crystal spherical silicon nanoparticles which showed a fluorescence peak in a visible light range of 400 nm to 600 nm. This is explained as that since the silicon nanoparticles of Comparative Example 1 are each a polycrystal which is an aggregate of single crystals with different crystallite diameters, electron energy levels for absorption of excitation light and for fluorescence emission are different from those of the single-crystal spherical silicon nanoparticles. In particular, this is because since the diameter of the silicon particles prepared in Examples and Comparative Examples was around 5 nm, a slight change in crystallite diameter had a large effect on the size of the band gap of silicon, and because a polycrystal includes grain boundaries where crystallites of each single crystal are in contact with each other, so that an electron energy level due to the presence of the grain boundaries exists.

Table 9 shows the average particle diameter, the circularity, the relative fluorescence quantum efficiency as well as the ratio: B/A and the ratio: C obtained from the IR spectra, of the polycrystalline silicon nanoparticles of Comparative Example 1-1 to Comparative Example 1-3. The silicon nanoparticles of Comparative Example 1 were polycrystalline silicon nanoparticles, and the values of the ratio: B/A and the ratio: C/A are 0.2 or more. It was confirmed that these values were different when compared to the ratio: B/A and the ratio: C/A of the single-crystal spherical silicon nanoparticles of Example 1 and Example 2.

[Table 9]

|  | Average particle diameter [nm] | Circularity | Relative fluorescence quantum efficiency [%] | B/A | C/A |
|---|---|---|---|---|---|
| Comparative Example 1-1 | 3.2 | 0.84 | 10 | 0.38 | 0.25 |
| Comparative Example 1-2 | 2.8 | 0.88 | 8 | 0.42 | 0.30 |
| Comparative Example 1-3 | 2.8 | 0.83 | 8 | 0.40 | 0.29 |

Example 3

Table 10 shows the formulations in Example 3-1 and Example 3-2. Table 11 shows the operation conditions of the fluid processing apparatus in Example 3-1 and Example 3-2. Table 9 shows the average particle diameter, the circularity, the relative fluorescence quantum efficiency as well as the ratio: B/A and the ratio: C obtained from the IR spectra, of the single-crystal spherical silicon nanoparticles of Example 3-1 and Example 3-2.

When the alkali metal in the reduction liquid was sodium, the relative fluorescence quantum efficiency was 11% to 13%. The values of the ratio: B/A and the ratio: C/A of the silicon nanoparticles of Example 3 are 0.1 or less. It was confirmed that these values were equivalent to the ratio: B/A and the ratio: C/A of the single-crystal spherical silicon nanoparticles of Example 1 and Example 2.

[Table 10]

|  | First fluid (Liquid A) (Single-crystal spherical silicon nanoparticle reduction liquid) | | | | Second fluid (Liquid B) (Single-crystal spherical silicon nanoparticle raw material liquid) | |
|---|---|---|---|---|---|---|
|  | Raw material | [mol/L] | Raw material | [mol/L] | Raw material | [mol/L] |
| Example 3-1 to Example 3-2 | Na | 0.4 | $C_{10}H_8$ | 0.4 | $SiBr_4$ | 0.1 |

[Table 11]

|  | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
|  |  | Liquid A | Liquid B | Liquid A | Liquid B | Liquid A | Liquid B |
| Example 3-1 | 3500 | 10 | 10 | 5 | 15 | <0.1 | <0.1 |
| Example 3-2 | 5000 | 10 | 10 | 5 | 15 | <0.1 | <0.1 |

[Table 12]

|  | Average particle diameter [nm] | Circularity | Relative fluorescence quantum efficiency [%] | B/A | C/A |
|---|---|---|---|---|---|
| Example 3-1 | 2.2 | 0.94 | 11 | 0.10 | 0.08 |
| Example 3-2 | 2.0 | 0.95 | 13 | 0.09 | 0.08 |

Example 4

Table 13 shows the formulations in Example 4-1 and Example 4-2. Table 14 shows the operation conditions of the fluid processing apparatus in Example 4-1 and Example 4-2. Table 15 shows the average particle diameter, the circularity, the relative fluorescence quantum efficiency as well as the ratio: B/A and the ratio: C obtained from the IR spectra, of the single-crystal spherical silicon nanoparticles of Example 4-1 and Example 4-2.

When the alkali metal in the reduction liquid was potassium, the relative fluorescence quantum efficiency was 11% to 13%. It was confirmed that the ratio B:A and the ratio: C/A were equivalent to the ratio: B/A and the ratio: C/A of the single-crystal spherical silicon nanoparticles of Example 1 to Example 3.

[Table 13]

| | First fluid (Liquid A) (Single-crystal spherical silicon nanoparticle reduction liquid) | | | | Second fluid (Liquid B) (Single-crystal spherical silicon nanoparticle raw material liquid) | |
|---|---|---|---|---|---|---|
| | Raw material | [mol/L] | Raw material | [mol/L] | Raw material | [mol/L] |
| Example 4-1 to Example 4-2 | K | 0.4 | $C_{10}H_8$ | 0.4 | $SiBr_4$ | 0.1 |

[Table 14]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
| | | Liquid A | Liquid B | Liquid A | Liquid B | Liquid A | Liquid B |
| Example 4-1 | 3500 | 10 | 10 | 5 | 15 | <0.1 | <0.1 |
| Example 4-2 | 5000 | 10 | 10 | 5 | 15 | <0.1 | <0.1 |

[Table 15]

| | Average particle diameter [nm] | Circularity | Relative fluorescence quantum efficiency [%] | B/A | C/A |
|---|---|---|---|---|---|
| Example 4-1 | 2.2 | 0.94 | 11 | 0.10 | 0.08 |
| Example 4-2 | 2.0 | 0.95 | 13 | 0.09 | 0.08 |

Comparative Example 2

Table 16 shows the formulations of Comparative Example 2-1 and Comparative Example 2-2. Table 17 shows the operation conditions of the fluid processing apparatus in Comparative Example 2-1 and Comparative Example 2-2. The alkali metal in the reduction liquid was metal lithium, and the temperature of the reduction liquid of Liquid A was set to 25°C. The disk rotation speed was set to 3500 rpm and 5000 rpm. Table 18 shows the average particle diameter, the circularity, the relative fluorescence quantum efficiency as well as the ratio: B/A and the ratio: C/A obtained from the IR spectra, of the single-crystal spherical silicon nanoparticles of Comparative Example 2-1 and Comparative Example 2-2.

Due to the high temperature of the reduction liquid of Liquid A, the average particle diameter was as large as 4 nm or more even when the disk rotation speed was high, and the relative fluorescence quantum efficiency decreased to less than 5%. It was confirmed that the values of the ratio: B/A and the ratio: C/A were different from and larger than the ratio: B/A and the ratio: C/A of the single-crystal spherical silicon nanoparticles of Example 1 to Example 4.

[Table 16]

| | First fluid (Liquid A) (Single-crystal spherical silicon nanoparticle reduction liquid) | | | | Second fluid (Liquid B) (Single-crystal spherical silicon nanoparticle raw material liquid) | |
|---|---|---|---|---|---|---|
| | Raw material | [mol/L] | Raw material | [mol/L] | Raw material | [mol/L] |
| Comparative Example 2-1 to Comparative Example 2-2 | Li | 0.4 | $C_{10}H_8$ | 0.4 | $SiCl_4$ | 0.1 |

[Table 17]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
| | | Liquid A | Liquid B | Liquid A | Liquid B | Liquid A | Liquid B |
| Comparative Example 2-1 | 3500 | 10 | 10 | 25 | 15 | <0.1 | <0.1 |
| Comparative Example 2-2 | 5000 | 10 | 10 | 25 | 15 | <0.1 | <0.1 |

[Table 18]

| | Average particle diameter [nm] | Circularity | Relative fluorescence quantum efficiency [%] | B/A | C/A |
|---|---|---|---|---|---|
| Comparative Example 2-1 | 4.5 | 0.92 | 3 | 0.45 | 0.32 |
| Comparative Example 2-2 | 4.2 | 0.94 | 4 | 0.35 | 0.30 |

Comparative Example 3

Table 19 shows the formulations of Comparative Example 3-1 and Comparative Example 3-2. Table 20 shows the operation conditions of the fluid processing apparatus in Comparative Example 3-1 and Comparative Example 3-2. The alkali metal in the reduction liquid of Liquid A was metal lithium, and the temperature of the reduction liquid was kept at 5°C. Table 21 shows the average particle diameter, the circularity, the relative fluorescence quantum efficiency as well as the ratio: B/A and the ratio: C/A obtained from the IR spectra, of the single-crystal spherical silicon nanoparticles of Comparative Example 3-1 and Comparative Example 3-2.

Although the temperature of the reduction liquid was kept at a low temperature of 5°C, setting the disk rotation speed to 350 rpm and 500 rpm increased the average particle diameter and decreased the relative fluorescence quantum efficiency to less than 5%. It was confirmed that the values of the ratio: B/A and the ratio: C/A were different from and larger than the ratio: B/A and the ratio: C/A of the single-crystal spherical silicon nanoparticles of Example 1 to Example 4.

[Table 19]

| | First fluid (Liquid A) (Single-crystal spherical silicon nanoparticle reduction liquid) | | | | Second fluid (Liquid B) (Single-crystal spherical silicon nanoparticle raw material liquid) | |
|---|---|---|---|---|---|---|
| | Raw material | [mol/L] | Raw material | [mol/L] | Raw material | [mol/L] |
| Comparative Example 3-1 to Comparative Example 3-2 | Li | 0.4 | $C_{10}H_8$ | 0.4 | $SiCl_4$ | 0.1 |

[Table 20]

| | Disk rotation speed [rpm] | Introduction flow rate (liquid sending flow rate) [mL/min] | | Introduction temperature (liquid sending temperature) [°C] | | Introduction pressure (liquid sending pressure) [MPaG] | |
|---|---|---|---|---|---|---|---|
| | | Liquid A | Liquid B | Liquid A | Liquid B | Liquid A | Liquid B |
| Comparative Example 3-1 | 350 | 10 | 10 | 5 | 15 | <0.1 | <0.1 |
| Comparative Example 3-2 | 500 | 10 | 10 | 5 | 15 | <0.1 | <0.1 |

[Table 21]

|  | Average particle diameter [nm] | Circularity | Relative fluorescence quantum efficiency [%] | B/A | C/A |
|---|---|---|---|---|---|
| Comparative Example 3-1 | 4.5 | 0.94 | 3 | 0.35 | 0.30 |
| Comparative Example 3-2 | 4.2 | 0.94 | 3 | 0.48 | 0.34 |

INDUSTRIAL APPLICABILITY

Since the single-crystal spherical silicon nanoparticles of the present invention are each a single crystal with no grain boundaries that reduce fluorescence efficiency, they can produce fluorescence at a high fluorescence quantum efficiency upon excitation by light in a wide range of wavelengths from deep ultraviolet light having a wavelength of 200 nm to 300 nm to visible light, and can increase the conventionally known fluorescence quantum efficiency of silicon nanoparticles from around 1% to 10% or more.

**Claims**

1.  Single-crystal spherical silicon nanoparticles,

    wherein the single-crystal spherical silicon nanoparticles are monocrystalline and spherical, and
    an average particle diameter of the single-crystal spherical silicon nanoparticles is 1 nm to 20 nm.

2.  The single-crystal spherical silicon nanoparticles according to claim 1,

    wherein the circularity of the single-crystal spherical silicon nanoparticles is calculated by a mathematical expression: $4\pi S/Z^2$ using a perimeter (Z) and an area (S) of a projected image of the single-crystal spherical silicon nanoparticles observed by a transmission electron microscope, and
    an average value of the circularity is 0.9 or more.

3.  The single-crystal spherical silicon nanoparticles according to claim 1 or 2,

    wherein the IR absorption spectrum of the single-crystal spherical silicon nanoparticles shows absorption in the wavenumber range of 1950 $cm^{-1}$ to 2150 $cm^{-1}$, and
    the absorption is attributed to Si-H bond.

4.  The single-crystal spherical silicon nanoparticles according to any one of claims 1 to 3, wherein the ratio: B/A calculated with A, which is the peak intensity of the maximum peak in the wavenumber range of 1000 $cm^{-1}$ to 1200 $cm^{-1}$, and B, which is the peak intensity of the maximum peak in the wavenumber range of 400 $cm^{-1}$ to 500 $cm^{-1}$, in the IR absorption spectrum of the single-crystal spherical silicon nanoparticles is less than 0.2.

5.  The single-crystal spherical silicon nanoparticles according to any one of claims 1 to 4, wherein the ratio: C/A calculated with A, which is the peak intensity of the maximum peak in the wavenumber range of 1000 $cm^{-1}$ to 1200 $cm^{-1}$, and C, which is the peak intensity of the maximum peak in the wavenumber range of 530 $cm^{-1}$ to 630 $cm^{-1}$, in the IR absorption spectrum of the single-crystal spherical silicon nanoparticles is less than 0.2.

6.  The single-crystal spherical silicon nanoparticles according to any one of claims 1 to 5, wherein the single-crystal spherical silicon nanoparticles exhibit a fluorescence maximum in the wavelength range of 400 nm to 600 nm.

7.  The single-crystal spherical silicon nanoparticles according to any one of claims 1 to 6, wherein the single-crystal spherical silicon nanoparticles exhibit a fluorescence maximum in the wavelength range of 400 nm to 600 nm by deep ultraviolet light at an excitation light wavelength of 300 nm or less.

FIG. 1

5nm

FIG. 2

2 nm

FIG. 3

FIG. 4

FIG. 5a

FIG. 5b

FIG. 5c

FIG. 5d

FIG. 6

FIG. 7

FIG. 8

FIG. 9

FIG. 10

FIG. 11

FIG. 12a

FIG. 12b

FIG. 12c

FIG. 12d

FIG. 13a

——— Example 1-4
(excitation wavelength: 220nm, fluorescence peak wavelength: 547nm)

------ Comparative Example 1-1
(excitation wavelength: 220nm, fluorescence peak wavelength: 400nm)

FIG. 13b

—— Example 1-4
(excitation wavelength: 260nm, fluorescence peak wavelength: 568nm)

------ Comparative Example 1-1
(excitation wavelength: 260nm, fluorescence peak wavelength: 399nm)

## INTERNATIONAL SEARCH REPORT

| International application No. |
| --- |
| **PCT/JP2022/020113** |

**A. CLASSIFICATION OF SUBJECT MATTER**

*C01B 33/18*(2006.01)i; *B82B 1/00*(2006.01)i; *B82Y 20/00*(2011.01)i; *C09K 11/59*(2006.01)i; *H01L 33/06*(2010.01)i; *H01L 33/34*(2010.01)i

FI: C01B33/18 Z; B82B1/00; B82Y20/00; C09K11/59; H01L33/06; H01L33/34

According to International Patent Classification (IPC) or to both national classification and IPC

**B. FIELDS SEARCHED**

Minimum documentation searched (classification system followed by classification symbols)

C01B33/00-33/193; B82; C09K11/59; H01L31/0352, 33/06, 33/34

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
| --- | --- | --- |
| X | BALCI, M. H. et al. Journal of Cluster Science. June 2012, vol. 23, pp. 421-435, DOI:10.1007/s10876-012-0448-0 abstract, p. 422, 1st paragraph, p. 423, 2nd paragraph to p. 424, 2nd paragraph, p. 426, 2nd paragraph to p. 427, 2nd paragraph, fig. 1-4, 8, 10, table 1 | 1-2, 5-7 |
| Y | | 6-7 |
| X | JP 2019-156665 A (UNIV HOSEI) 19 September 2019 (2019-09-19) claims, paragraphs [0001], [0004], [0011]-[0013], [0026], fig. 1, 10, table 1 | 1-3, 5-7 |
| Y | | 6-7 |
| X | JP 2010-534141 A (THE ADMINISTRATORS OF THE TULANE EDUCATIONAL FUND) 04 November 2010 (2010-11-04) claims, paragraphs [0006]-[0056], [0066], [0069], [0080]-[0081], [0092]-[0093], fig. 2-5, 20, 23-24, table 1 | 1-3, 5-7 |
| Y | | 6-7 |

☑ Further documents are listed in the continuation of Box C.  ☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **01 July 2022** | **26 July 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT

International application No.

**PCT/JP2022/020113**

### C.    DOCUMENTS CONSIDERED TO BE RELEVANT

| Category* | Citation of document, with indication, where appropriate, of the relevant passages | Relevant to claim No. |
|---|---|---|
| X | SETO, T. et al. Nano Letters. 13 June 2001, vol. 1, pp. 315-318, DOI:10.1021/nl015530n abstract, p. 315, left column, 1st paragraph, p. 316, left column, 1st paragraph to p. 318, right column, 2nd paragraph, fig. 1-2, 4, 6 | 1-2, 5 |
| Y | | 6-7 |
| X | JP 2016-216579 A (UNIV GUNMA) 22 December 2016 (2016-12-22) examples 1, 2, claims, paragraphs [0001], [0005]-[0012], [0016]-[0018], [0026], [0036], [0047], fig. 4 | 1-2, 6-7 |
| A | WO 2007/025793 A1 (DEGUSSA AG) 08 March 2007 (2007-03-08) entire text, all drawings | 1-7 |
| A | JP 2009-504423 A (INNOVALIGHT, INC) 05 February 2009 (2009-02-05) entire text, all drawings | 1-7 |
| A | JP 2015-201621 A (NAT INST FOR MATERIALS SCIENCE) 12 November 2015 (2015-11-12) entire text, all drawings | 1-7 |
| A | WO 2009/020188 A1 (M.TECHNIQUE CO., LTD.) 12 February 2009 (2009-02-12) entire text, all drawings | 1-7 |
| A | JP 2007-012702 A (TOSHIBA CORP) 18 January 2007 (2007-01-18) entire text, all drawings | 1-7 |

Form PCT/ISA/210 (second sheet) (January 2015)

43

**INTERNATIONAL SEARCH REPORT**
Information on patent family members

| International application No. |
| --- |
| **PCT/JP2022/020113** |

| Patent document cited in search report | | | Publication date (day/month/year) | Patent family member(s) | Publication date (day/month/year) |
| --- | --- | --- | --- | --- | --- |
| JP | 2019-156665 | A | 19 September 2019 | (Family: none) | |
| JP | 2010-534141 | A | 04 November 2010 | US 2009/0047773 A1 claims, paragraphs [0004]-[0056], [0092], [0097], [0117]-[0118], [0092], fig. 2-5, 20, 23-24, table 1 <br> WO 2009/011981 A2 <br> EP 2162386 A2 <br> KR 10-2010-0038082 A <br> CA 2724951 A | |
| JP | 2016-216579 | A | 22 December 2016 | (Family: none) | |
| WO | 2007/025793 | A1 | 08 March 2007 | US 2010/0221544 A1 <br> EP 1760045 A1 | |
| JP | 2009-504423 | A | 05 February 2009 | US 2008/0248307 A1 entire text, all drawings <br> WO 2007/117265 A2 <br> EP 1922746 A2 | |
| JP | 2015-201621 | A | 12 November 2015 | (Family: none) | |
| WO | 2009/020188 | A1 | 12 February 2009 | US 2011/0042626 A1 entire text, all drawings <br> US 2015/0034884 A1 <br> US 2010/0155310 A1 <br> JP 2009-82902 A <br> JP 2011-189348 A <br> WO 2009/008393 A1 <br> EP 2184772 A1 <br> EP 2184109 A1 <br> EP 3106227 A1 <br> CN 101855713 A <br> CN 101795772 A <br> CN 102516809 A <br> KR 10-2010-0053629 A <br> KR 10-2014-0013113 A <br> KR 10-2010-0022093 A <br> TW 200918156 A | |
| JP | 2007-012702 | A | 18 January 2007 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014172766 A
- JP 2017081770 A
- JP 2010205686 A
- JP 2007012702 A
- JP 4458202 B
- JP 2009112892 A